Europäisches Patentamt

European Patent Office

Office européen des brevets

(19)

(11) Numéro de publication: **0 211 711**
**B1**

(12) **FASCICULE DE BREVET EUROPEEN**

(45) Date de publication du fascicule du brevet: **02.01.91**

(51) Int. Cl.⁵: **G 01 R 27/06,** G 01 R 27/16

(21) Numéro de dépôt: **86401427.9**

(22) Date de dépôt: **27.06.86**

(54) Procédé et dispositif pour le test rapide, par réflectométrie, dans les gammes VHF, de composants passifs.

(30) Priorité: **01.07.85 FR 8510007**

(43) Date de publication de la demande:
**25.02.87 Bulletin 87/09**

(45) Mention de la délivrance du brevet:
**02.01.91 Bulletin 91/01**

(84) Etats contractants désignés:
**AT BE CH DE FR GB IT LI LU NL SE**

(56) Documents cités:
**FR-A-2 514 902**

**HEWLETT-PACKARD JOURNAL, vol. 31, no. 1, janvier 1980, pages 22-32, Palo Alto, California, US; T. ICHINO et al.: "Vector impedance analysis to 1000 MHz"**

**ELECTRONICS, vol. 32, no. 43, 23 octobre 1959, pages 120,121, New York, US; J. HANSON: "Unconventional technique for measuring VSWR"**

(73) Titulaire: **UNIVERSITE DE RENNES I**
**Campus de Beaulieu Avenue du Général Leclerc**
**F-35000 Rennes (FR)**

(72) Inventeur: **Le Traon, André**
**18, rue des Tilleuls**
**F-35510 Cesson-Sevigne (FR)**
Inventeur: **Haraoubia, Brahim**
**Université de Rennes Campus de Beaulieu**
**F-35042 Rennes Cédex (FR)**
Inventeur: **Pilet, Jean-Claude**
**27, Boulevard Charles Péguy**
**F-35000 Rennes (FR)**
Inventeur: **De Burgat, Michel**
**16, rue du Papier timbré**
**F-35000 Rennes (FR)**
Inventeur: **Meury, Jean-Loic**
**99, rue de la belle Epine**
**F-35510 Cesson-Sevigne (FR)**
Inventeur: **Le Traon, Flore**
**18, rue des Tilleuls**
**F-35510 Cesson-Sevigne (FR)**

(74) Mandataire: **Martin, Jean-Jacques et al**
**Cabinet REGIMBEAU 26, Avenue Kléber**
**F-75116 Paris (FR)**

Courier Press, Leamington Spa, England.

# EP 0 211 711 B1

(56) References cited:

TELECOMMUNICATIONS & RADIO ENGINEERING, vol. 35/36, no. 4, avril 1981, pages 103-105, Silver Spring, Maryland, US; L.I. BABAK: "A frequency method of measuring the scattering parameters of microwave four-poles"

MICROWAVE JOURNAL, vol. 10, no. 1, janvier 1967, pages 79-83, Dedham, US: "Complex impedance and gain measurement at RF and microwave frequencies"

J.Osinga et al.:Handbuch der elektronischen Messgeräte 1984,Franzis - Druck GmbH,München,pages 262,263,266 à 269

# EP 0 211 711 B1

**Description**

La présente invention concerne le test de dipôles passifs, en particulier de condensateurs.

Plus précisément, la présente invention concerne un procédé et un dispositif pour le test rapide, par réflectrométrie, dans les gammes V.H.F., de composants passifs.

Le document "J. Osimaga et al.: Handbuch der elektronischen Messgeräte, 1984, Franzis-Druck GmbH, München, pages 262, 263, 266 à 269" décrit un dispositif formant réflectromètre qui comprend un générateur de signal électrique de fréquence variable dans la gamme V.H.F., une ligne connectée à une extrémité à un dipôle attesté formant impédance terminale, et par l'autre extrémité à un ensemble comprenant un premier coupleur directif et un deuxième coupleur directif conçus pour être intercalés entre le générateur et la ligne de sorte que le premier coupleur directif détecte un premier signal représentatif de l'onde réfléchie, et que le deuxième coupleur directif détecte un deuxième signal représentatif de l'onde incidente et des moyens de traitement comprenant des amplificateurs logarithmiques et un différenciateur pour former un signal de sortie représentatif du rapport entre le premier et le deuxième signal, ainsi qu'un écran de visualisation qui reçoit sur son entrée Y le signal de sortie précité et qui reçoit sur son entrée X un signal en dents de scie correspondant à la modulation en fréquence de générateur. Le réflectromètre comprend en outre un troisième coupleur directif conçu pour être connecté entre le dipôle à tester et une résistance terminale, sur une ligne auxiliaire de sortie, pour détecter un troisième signal représentatif de l'onde transmise par le dipôle à tester, ainsi que des moyens de traitement comprenant des amplificateurs logarithmiques et un deuxième différenciateur pour former un deuxième signal de sortie représentatif du rapport entre le troisième et le deuxième signal, ce deuxième signal de sortie pouvant être appliqué à l'entrée Y de l'écran de visualisation, à la place du premier signal de sortie.

Le document Electronics, Vol. 32, n° 43 (1959), pages 120, 121; J. Hanson: "Unconventional technique for measuring VSWR" décrit un dispositif de test d'antenne dans la gamme V.H.F. qui comprend un générateur V.H.F. conçu pour être couplé à l'antenne par une ligne et un coupleur directif conçu pour être intercalé sur la ligne afin de délivrer un premier signal représentatif de l'onde incidente et un deuxième signal représentatif de l'onde réfléchie. Selon ce document le coupleur directif est de type RC. La bande de fréquence utilisable est donc limitée. Le document indique que la bande de fréquence utilisable va de 150 à 175 MHz.

Un premier but de la présente invention est de réaliser un dispositif de test rapide, dans la gamme V.H.F., des dipôles passifs, à l'aide de moyen technologiques simples et selon un coût de revient très faible.

Un autre but de la présente invention est de permettre de déporter le dipôle sous test, à l'aide d'une ligne de transmission, par rapport à l'électronique de mesure, afin d'autoriser les tests de composants sous contraintes externes, telles que de fortes variations thermiques, par exemple en enceintes climatiques.

Un autre but de la présente invention est de permettre l'acquisition de l'ensemble des données couvrant la gamme de fréquences V.H.F., soit de l'ordre de 1 à 200 MHz, en un temps très court de l'ordre d'une seconde.

Un autre but de la présente invention est de permettre d'automatiser aisément le processus de test.

Ces différents buts sont atteints selon la présente invention grâce à un procédé de test rapide, dans la gamme V.H.F., de dipôles passifs, comprenant les étapes consistant à:

i) connecter un générateur de signal électrique de fréquence située dans la gamme V.H.F. en tête d'une ligne et à connecter le dipôle à tester à l'autre extrémité de la ligne, sous forme d'impédance terminale,

ii) alimenter la ligne, grâce au générateur, par une onde incidente $v_i$ périodique dont la fréquence est modulable dans la gamme V.H.F. pendant la durée du test,

iii) détecter, en tête de ligne, un premier signal représentatif de l'onde réfléchie $v_r$ et un second signal représentatif de l'onde incidente $v_i$ grâce à un module intercalé entre le générateur et la ligne, pour défninir l'évolution du coefficient de réflexion sur la gamme V.H.F. et déterminer de ce coefficient de réflexion l'impédance du dipôle à tester, caractérisé par le fait que:

— la ligne est constituée d'une ligne à constantes réparties présentant une impédance caractéristique égale à l'impédance interne du générateur,

— le module intercalé entre le générateur et la ligne est formé d'un réseau résistif en π comprenant une borne d'entrée destinée à être raccordée à la sortie du générateur et une borne de sortie destinée à être raccordée à la ligne, et le module est constitué:

. d'une première branche comprenant une première et une deuxième résistances connectées en série entre la borne d'entrée et la masse, et un premier point médian de sortie situé entre ces deux résistances dans laquelle la première résistance de cette première branche, située entre la masse et le premier point médian de sortie a une valeur égale aux 2/3 de l'impédance caractéristique de la ligne, tandis que la deuxième résistance de cette première branche, située entre la borne d'entrée et le premier point médian de sortie a une valeur égale aux 4/3 de l'impédance caractéristique de la ligne,

. d'une deuxième branche comprenant une première et une deuxième résistances connectées en série entre la borne de sortie et la masse, et un deuxième point médian de sortie situé entre ces deux résistances dans laquelle la prmeière résistance de cette deuxième branche, située entre la masse et le deuxième point médian de sortie a une valeur égale aux 2/3 de l'imédance caractéristique de la ligne tandis que la deuxième résistance de cette deuxième branche, située entre la borne de sortie et le deuxième point médian de sortie a une valeur égale aux 4/3 de l'impédance caraactéristique de la ligne, et

. d'une troisième branche comprenant une résistance connectée entre la borne d'entrée et la borne de sortie, et qui a une valeur égale aux 4/3 de l'impédance caractéristique de la ligne, et comprenant les étapes consistant à:

— mesurer un premier signal représentatif de l'onde réfléchie Vr, entre la borne de sortie et le premier point médian de sortie prévu sur la première branche, et

— mesurer un second signal représentatif de l'onde incidente Vi, entre la borne d'entrée et le deuxième point médian de sortie prévu sur la deuxième branche.

Selon une caractéristique avantageuse de l'invention, à l'étape *ii)* la ligne est alimentée par une onde incidente $v_i$ périodique dont la période varie sur une gamme de l'ordre de 1 µseconde à 5 ns sur une durée de test d'environ 1 seconde.

Selon l'invention, au cours de l'étape *ii)*, la ligne est avantageusement alimentée par une onde incidente $v_i$ dont la période est modulée par vobulation sur la gamme V.H.F. selon une fonction linéaire ou logarithmique du temps.

Le procédé de test rapide conforme à la présente invention trouve notamment application dans l'analyse de condensateurs pour lesquels le module d'admittance Y du dipôle évolue comme une suite de paliers de valeurs $G_j$, ceux-ci étant déterminés à l'étape *iii)* sur la base de la relation:

$$G_j = \frac{1}{R_c} \ \frac{1 - |\Gamma_j|}{1 + |\Gamma_j|} \qquad \text{(1) dans laquelle}$$

$R_c$ représente l'impédance caractéristique de la ligne et
$|\Gamma_j|$ représente le module du coefficient de réflexion.

Plus précisément encore, le procédé de test rapide conforme à la présente invention permet l'analyse de condensateurs sous forme d'un réseau de n branches parallèles comportant chacune en série une résistance $R_j$ et une capacitance $c_j$, la résistance $R_j$ et la capacitance $C_j$ étant déterminés à l'étape *iii)* sur la base des relations:

$$1/R_j = G_j - G_{j-1} \qquad \text{(2) dans laquelle}$$

$G_j$ et $G_{j-1}$ représentent deux paliers successifs du module d'admittance $|Y|$, et

$$C_j = (G_j - G_{j-1})/w_j \qquad \text{(3) dans laquelle}$$

$\omega_j$ représente la pulsation critique de la branche considérée.

Selon une autre caractéristique avantageuse de la présente invention, l'étape *ii)* est réalisée à l'aide d'un oscillateur à fréquence variable à commutation automatique de bandes de fréquence intégré au générateur.

Selon une autre caractéristique avantageuse de l'invention, le circuit bouchon de l'oscillateur est associé à une diode varicap polarisée par un signal en dent de scie assurant la vobulation à l'intérieur de chaque bande de fréquence, le circuit bouchon de l'oscillateur comportant une pluralité de selfs progressivement mises en service pour assurer la commutation de bandes de fréquence.

Selon une caractéristique préférentielle de la présente invention, les signaux de commutation de bandes de fréquence assurant progressivement la mise en service des selfs du circuit bouchon de l'oscillateur sont générés à partir du signal en dents de scie polarisant la diode varicap. On obtient ainsi une synchronisation automatique entre la commutation de bandes de fréquence et la vobulation à l'intérieur de chacune des bandes.

Selon une autre caractéristique avantageuse de la présente invention, les signaux de commutation de bandes de fréquence sont générés en sortie d'un registre à décalage à entrée série et sorties parallèles commandé par le générateur de signal en dents de scie.

La présente invention concerne également un dispositif de test rapide dans la gamme V.H.F. de dipôles passifs comprenant:

— un générateur de signal électrique de fréquence variable dans la gamme V.H.F.

— une ligne connectée en sortie au dipôle à tester formant impédance terminale, et en tête audit générateur par l'intermédiaire

— d'un module conçu pour séparer un premier signal représentatif de l'onde réfléchie $v_r$ et un second signal représentatif de l'onde incidente $v_i$ lorsque la ligne est alimentée par une onde incidente $v_i$ périodique dont la fréquence est modulée dans la gamme V.H.F. pendant la durée du test, pour définir l'évolution du coefficient de réflexion sur la gamme V.H.F. et déterminer de ce coefficient de réflexion l'impédance du dipôle à tester caractérisé par le fait que:

— la ligne est une ligne à constantes réparties présentant une impédance caractéristique égale à l'impédance interne du générateur,

— le module intercalé entre le générateur et la ligne est un réseau résistif en π comprenant une borne d'entrée destinée à être raccordée à la sortie du générateur et une borne de sortie destinée à être raccordée à la ligne, et le module est constitué:

. d'une première branche comprenant une première et une deuxième résistances connectées en série entre la borne d'entrée et la masse, et un premier point médian de sortie situé entre ces deux résistances dans laquelle la première résistance de cette première branche, située entre la masse et le premier point médian de sortie a une valeur égale aux 2/3 de l'impédance caractéristique de la ligne, tandis que la deuxième résistance de cette première branche, situées entre la borne d'entrée et le premier point médian de sortie a une valeur égale aux 4/3 de l'impédance caractéristique de la ligne,

. d'une deuxième branche comprenant une première et une deuxième résistances connectées en série entre la borne de sortie et la masse, et un deuxième point médian de sortie situé entre ces deux résistances dans laquelle la première résistance de cette deuxième branche, située entre la masse et le deuxième point médian de sortie a une valeur égale aux 2/3 de l'impédance caractéristique de la ligne tandis que la deuxième résistance de cette deuxième branche, située entre la borne de sortie et le deuxième point médian de sortie a une valeur égale aux 4/3 de l'impédance caraactéristique de la ligne, et

. d'une troisième branche comprenant une résistance connectée entre la borne d'entrée et la borne de sortie, et qui a une valeur égale aux 4/3 de l'impédance caractéristique de la ligne, et comprenant:

— des moyens aptes à prélever un premier signal représentatif de l'onde réfléchie $V_r$, entre la borne de sortie et le premier point médian de sortie prévu sur la première branche,

— des moyens aptes à prélever un second signal représentatif de l'onde incidente $V_i$ entre la borne d'entrée et le deuxième point médian de sortie prévu sur la deuxième branche, et

— des moyens aptes à former le rapport entre le premier signal et le second signal pour former un signal représentatif du module du coefficient de réflexion.

D'autres caractéristiques et avantages de la présente invention apparaîtront à la lecture de la description détaillée qui va suivre; et en regard des dessins annexés, donnés à titre d'exemples non limitatifs et sur lesquels:

— la figure 1 illustre le principe général de test conforme à la présente invention,

— la figure 2 illustre la représentation sous forme d'un schéma standard équivalent de Foster d'un condensateur imparfait,

— la figure 3 représente le module $|Y_i| \cdot R_i$ d'admittance d'une branche du schéma précité,

— la figure 4 représente l'argument de l'admittance de la même branche du schéma,

— la figure 5 représente une vue schématique du module de réflectrométrie conforme à la présente invention permettant de séparer l'onde réfléchie $V_r$ et l'onde incidente $v_i$,

— la figure 6 représente une vue plus détaillée du module de réflectrométrie,

— la figure 7 représente une vue générale schématique, sous forme de blocs fonctionnels, du générateur utilisé dans le dispositif de test conforme à la présente invention,

— la figure 8 représente une vue schématique de l'oscillateur intégré au générateur précité,

— la figure 9 représente une vue du même oscillateur en combinaison avec un bloc de selfs à commuter, un générateur de signaux de commutation de bandes et un générateur de dents de scie polarisant une diode varicap associée à l'oscillateur pour assurer la vobulation à l'intérieur de chaque bande de fréquence,

— la figure 10 représente une vue schématique du générateur de dents de scie,

— la figure 11 illustre schématiquement la réalisation du générateur de dents de scie et du générateur de signaux de commutation de bandes synchronisés, conforme au mode de réalisation préférentiel de la présente invention,

— la figure 12 illustre un chronogramme de différents signaux représentatif du fonctionnement du générateur conforme à la présente invention.

— les figures 13 à 16 illustrent différents résultats de mesure conforme à la présente invention.

## PRINCIPE GENERAL DU TEST CONFORME A LA PRESENTE INVENTION

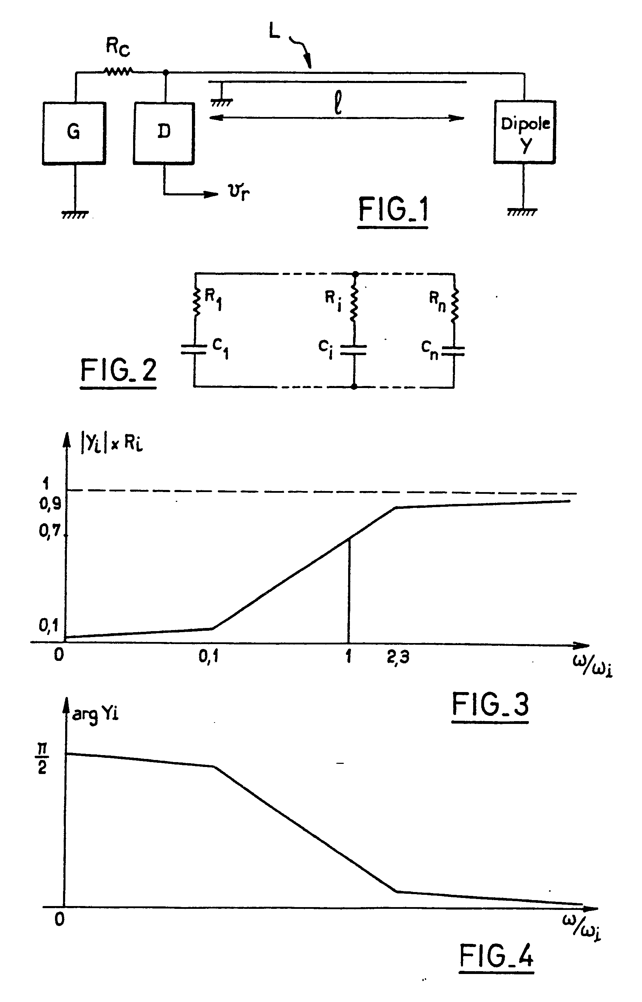

Comme cela est illustré schématiquement sur la figure 1, le processus de test conforme à la présente invention utilise un générateur G de signal électrique de fréquence variable dans la gamme V.H.F., connecté en tête d'une ligne à constantes réparties, en sortie de laquelle est relié le dipôle à tester, sous forme d'impédance terminale.

Le principe général du test consiste à alimenter la ligne L à constantes réparties, de longueur 1, par une onde incidente $v_i$ périodique dont on fait varier la période, par exemple d'1 µseconde à 5 ns pendant la durée très courte du test de l'ordre de 1 seconde, par vobulation selon une fonction linéaire ou logarithmique du temps, et à détecter en tête de la ligne l'onde $v_r$ réfléchie par le dipôle sous test inséré sous forme d'impédance terminale de la ligne.

Sur la figure 1, l'élément de détection de l'onde $v_r$ réfléchie par le dipôle est référencé schématiquement D.

L'ensemble comprenant le générateur G et l'élément de détection D, vu de l'entrée de la ligne L présente une impédance interne égale à l'impédance caractéristiquȩ $R_c$ (avantageusement $R_c$ = 50 ohms) de la ligne, pour réaliser l'adaptation en entrée de cette ligne.

5

# EP 0 211 711 B1

Comme on l'a évoqué précédemment et comme cela sera décrit plus en détail par la suite, selon la présente invention, la séparation de l'onde incidente $v_i$ et de l'onde réfléchie $v_r$ est réalisée à l'aide d'un module de réflectométrie résistif.

## ANALYSE GENERALE DES DIPOLES PASSIFS LINEARES

Un dipôle passif linéaire est un réseau comportant deux pôles d'accès entre lesquels se développe un maillage de n branches. Chaque branche est constituée par le mise en série d'une résistance, d'une self inductance et d'une capacitance, l'un ou l'autre ou plusieurs de ces éléments pouvant être nul ou infini.

L'interaction du dipôle avec un circuit électrique dans lequel il est inséré est entièrement caractérisé par son admittance Y ou son impédance Z, abstraction faite de la structure réelle interne du réseau constituant le dipôle.

Le cas d'un dipôle constitué uniquement de deux types d'éléments: self inductance et capacitance, ou self inductance et résistance, ou capacitance et résistance, est justifiable du théorème de Foster. Dans un tel cas, le réseau réel constituant le dipôle peut à toutes fréquences être remplacé par un réseau standard dont le comportement externe lui est rigoureusement équivalent.

Pour un condensateur imparfait, c'est-à-dire présentant des pertes équivalent à des éléments purement résistifs, le schéma standard équivalent de Foster en admittance est illustré sur la figure 2.

Plus précisément, ce schéma standard comprend un réseau de n branches parallèles comportant chacune en série une résistance $R_i$ et une capacitance $C_i$.

L'admittance Y du dipôle s'exprime par la relation:

$$Y = \sum_{i=1}^{n} Y_i \quad (6) \text{ avec}$$

$$Y_i = \frac{j\, C_i\, \omega}{1 + j\, R_i\, C_i\, \omega} \quad (7)$$

On a représenté respectivement sur les figures 3 et 4, en fonction des ordonnées $\omega/\omega_i$, le module $|Y_i| \cdot R_i$ du module d'admittance d'une branche du dipôle illustré sur la figure 2, d'une part, et l'argument de l'admittance $Y_i$ d'autre part.

Le comportement d'une branche, la $i^{eme}$, est caractérisé par la valeur de sa constante de temps $\tau_i = R_i C_i$ par rapport à la pulsation $\omega$.

Comme cela apparaît à l'examen des figures 3 et 4, pour une pulsation $\omega < 1/\tau_i$, la branche considérée présente une admittance capacitive tendant vers zéro lorsque $\omega$ décroit.

Par contre, pour une pulsation $\omega > 1/\tau_i$, la branche considérée présente une conductance limite tendant vers une asymptote constante $1/R_i$ lorsque $\omega$ croit.

Enfin, pour une pulsation $\omega \cong 1/\tau_i$, le comportement de la branche considérée présente une forte variation de l'admittance en module et en phase, comme cela apparaît respectivement sur les figures 3 et 4 annexés.

La zone de variation s'étend sur environ 1,5 décade de fréquence entourant la pulsation critique $\omega_i = 1/\tau_i$. En deça, la branche apporte une contribution voisine de zéro à l'admittance Y totale et tend à se comporter comme un circuit ouvert. Au-delà, la branche ajoute une conductance $1/R_i$ à l'admittance globale.

Si deux ou plusieurs branches ont des pulsations critiques $\omega_i$ dans leur intervalle de 1,5 décade, et parconséquent se "recouvrent", on montre qu'une représentation satisfaisante à quelques pour cent près, de leur contribution à l'admittance globale Y peut être donnée par l'addition de deux branches $Y_a$ et $Y_b$ dont les caractéristiques $R_a C_a$ et $R_b C_b$ sont des valeurs moyennes des caractéristiques $R_i C_i$ des n branches concernées, soit:

$$\sum_{i=j}^{k} Y_i = Y_a + Y_b \quad (8)$$

Le relevé du module $|Y_i(\omega)|$ de l'admittance d'une branche de constante de temps $\tau_i$ sur une variation de pulsation couvrant 1,5 décade autour de la pulsation critique $\omega_i = 1/\tau_i$ permet de déterminer les paramètres caractéristiques $\tau_i$ et $1/R_i$ et par suite $C_i$.

De la même manière, le relevé du module de l'admittance $|Y(j\omega)|$ sur un de pulsation intervalle de 2,3 décades, permet la détermination des caractéristiques $R_a C_a$, $R_b C_b$, $R_d C_d$ d'un schéma à 3 branches suffisant pour décrire sur la gamme de fréquences considéré le comportement en module et en phase (ou conductance et susceptance) du dipôle sous test.

6

Le principe général de détermination des paramètres $R_i$ et $C_i$ a été évoqué dans la demande de brevet Française déposée au nom de la Demanderesse le 10.05.1984 sous le N. 84 07196 et publiée sous le N. 2 564 205. On se reportera utilement à la description de cette demande de brevet pour la bonne compréhension de la présente invention.

PRINCIPE GENERAL D'OBTENTION DE L'ADMITTANCE DU DIPOLE PAR REFLECTOMETRIE

On va dans un premier temps décrire les équations générales relatives à l'obtention de l'admittance du dipôle par réflectrométrie.

Dans l'écriture de ces équations, on appellera:

$v_i$ la tension incidente appliquée sur la ligne L par le générateur G,

$v_r$ la tension réfléchie par le dipôle inséré sous forme d'impédance terminale, à l'entrée de la ligne,

l la longueur de la ligne,

Y l'admittance inconnue à tester,

Γ le coefficient de réflexion dû au dipôle Y,

$R_c$ la résistance caractéristique de la ligne,

$\gamma = \alpha + j\beta$ la constante de propagation,

α (ω) l'atténuation, fonction connue de la pulsation et pratiquement nulle pour une longueur de ligne faible,

$\beta = \dfrac{\omega}{v}$ la constante de phase,

v la vitesse de propagation.

On obtient:

$$\Gamma = \frac{1 - R_c Y}{1 + R_c Y} \quad \text{d'où} \tag{9}$$

$$Y_{(j\omega)} = \frac{1}{R_c}\, \frac{1 - \Gamma(\omega)}{1 + \Gamma(\omega)} = \frac{1}{R_c}\, \frac{1 - \dfrac{v_r}{v_i} e^{2\gamma l}}{1 + \dfrac{v_r}{v_i} e^{2\gamma l}} \tag{10}$$

$$|\Gamma| = \left| \frac{v_r}{v_i} \right| e^{2\alpha(\omega)\, l} \quad \text{et} \tag{11}$$

$$\arg\Gamma = \arg \frac{v_r}{v_i} + \frac{2l}{v}\,\omega \tag{12}$$

D'autre part, la tension totale $v_t$ en entrée de ligne s'écrit

$$v_t = v_i + v_r = v_i (1 + \Gamma\, e^{-2\gamma l}) \tag{13}$$

On obtient par ailleurs

$$\cos \varphi = \frac{|v_t|^2 - (|v_i|^2 + |v_r|^2)}{2\,|v_i|\,|v_r|} \quad \text{(13 bis) en posant}$$

$$\varphi = \arg \frac{v_r}{v_i} \quad \text{(13 ter)}$$

CAS DU CONDENSATEUR IMPARFAIT

Dans le cas d'un condensateur, pour la pulsation ω, les branches dont la pulsation critique $\omega_i$ est inférieure ou égale à $\omega/2,3$, se comportent comme des conductances $G_i = 1/R_i$ et la contribution de l'ensemble de ces branches 1 à $j - 1$ à l'admittance Y s'écrit:

$$G_j = \sum_{i=1}^{j-1} \frac{1}{R_i} \ . \tag{14}$$

7

Par contre, les branches pour lesquelles la pulsation critique $\omega_i$ est supérieure à 10 $\omega$, ont un module d'admittance qui tend vers zéro et un argument vers

$$\frac{\pi}{2}.$$

Ces branches n'affectent pratiquement pas la valeur de $|Y|$ et ces branches se comportent comme des circuits ouverts. Le terme principal d'admittance est donc $G_j$ augmenté de la contribution des branches "actives" pour lesquelles la pulsation critique $\omega_i$ est voisine de $\omega$.

Lorsqu'on fait croître $\omega$, des branches successives du schéma de Foster passent d'un comportement de circuit ouvert à un comportement de conductivité $1/R_i$.

Le module d'admittance $|Y|$ évolue donc comme une suite de paliers de valeur $G_j$ séparés par des régions de forte variation correspondant à l'activité des branches j que encadrent la pulsation:

$$\omega_j = \frac{1}{R_j C_j} \tag{15}$$

Cette évolution est suivie par le coefficient de réflexion. En effet, aux valeurs $G_j$ évoluant par paliers correspondent des paliers

$$\Gamma_j = \frac{1 - R_c G_j}{1 + R_c G_j} \tag{16}$$

où le coefficient de réflexion est purement réel, séparé par des régions de forte variation représentant "l'activité" de la branche j, pour lesquelles:

$$\Gamma_j(\omega) = \Gamma_j + \frac{\Gamma_{j-1} - \Gamma_j}{1 + jT_j \omega} \tag{17}$$

avec

$$T_j = R_j C_j \tag{18}$$

A la pulsation $\omega_j$ définie par la relation (15) correspond un module

$$|\Gamma_j(\omega_j)| = \frac{1}{2} \sqrt{\Gamma_j^2 + \Gamma_{j-1}^2} \tag{19}$$

On obtient ainsi :

$$G_j = \frac{1}{R_c} \frac{1 - |\Gamma_j|}{1 + |\Gamma_j|} \qquad \text{puis} \tag{1}$$

$$\frac{1}{R_j} = G_j - G_{j-1} \tag{2}$$

et simultanément

$$C_j = \frac{G_j - G_{j-1}}{\omega_j} \tag{3}$$

La procédure qui vient d'être décrite s'applique bien lorsque le rapport des constantes de temps $T_j/T_{j-1} \geqslant 18$, c'est-à-dire lorsque les branches actives sont nettement séparées.

Un traitement un peu plus complexe est nécessaire dans la cas contraire, c'est-à-dire dans le cas où l'on constate un recouvrement des branches actives. Cependant, ce traitement fait intervenir que le module $|\Gamma|$.

Dans le cas d'un dipôle passif quelconque, il est nécessaire de connaître $|v_i|$, $|v_r|$ et $|v_t|$ et l'obtention des modules de ces trois tensions à une pulsation $\omega$ donnée suffit pour déterminer $Y(\omega)$.

On va maintenant décrire la structure du module de réflectrométrie proposé selon la présente invention.

STRUCTURE DU MODULE DE REFLECTOMETRIE CONFORME A LA PRESENTE INVENTION

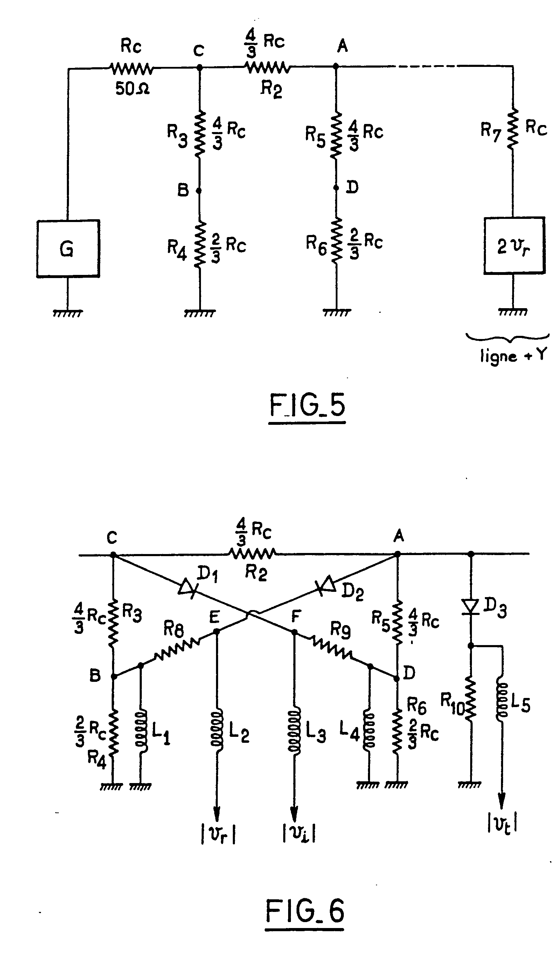

Ce module de réflectométrie est illustré sur les figures 5 et 6 annexées.

Le module de réflectométrie est destiné à être intercalé entre le générateur G d'impédance interne $R_c$ et la ligne d'impédance caractéristique $R_c$.

Selon la présente invention, le module de réflectométrie est formé d'un réseau en $\pi$ purement résistif présentant une impédance caractéristique $R_c$ (par exemple $R_c = 50$ ohms) permettant de maintenir l'adaptation du générateur et de l'entrée de la ligne.

Vis-à-vis de ce réseau, on montre que la ligne L terminée par l'admittance Y a le comportement d'une branche de sortie formée d'une résistance $R_c$ en série avec une f.e.m. $2v_r$ comme illustré sur la droite de la figure 5.

Ce module de réflectométrie en $\pi$ comprend deux branches identiques reliées par une résistance $R_2$ dont les bornes constituent respectivement l'entrée et la sortie du réseau re résistif en $\pi$. Chacune des branches du réseau comprend deux résistances $R_3$, $R_4$ d'une part, $R_5$, $R_6$ d'autre part connectées en série.

Par ailleurs, selon la présente invention, chaque cellule formée de l'impédance caractéristique $R_c$ de la ligne en parallèle sur l'une des branches $R_3$, $R_4$ ou $R_5$, $R_6$ du réseau résistif en $\pi$ présente une impédance identique à la première résistance $R_4$, $R_6$ de chaque branche connectée entré en point médian et la masse, tandis que la résistance $R_2$ du réseau en $\pi$ reliant les deux branches de celui-ci possède une impédance identique à la seconde résistance $R_3$, $R_5$ de chaque branche connectée entre ledit point médian et l'entrée ou la sortie du réseau.

Plus précisément, selon un mode de réalisation considéré comme préférentiel, de la présente invention, et tel que cela est illustré sur les figures 5 et 6 annexées, les premières résistances $R_4$, $R_6$ de chaque branche du réseau en $\pi$ ont une valeur de $2/3$ $R_c$ et le secondes résistances $R_3$, $R_5$ de chaque branche du réseau en $\pi$ ainsi que la résistance de liaison $R_2$ ont une valeur de $4/3$ $R_c$, $R_c$ représentant l'impédance caractéristique de la ligne.

Ainsi, le premier signal représentatif de l'onde réfléchie $v_r$ est pris entre le point A de connexion du module de réflectométrie à la ligne et un point médian B de la branche amont du module résistif en $\pi$, tandis que le second signal représentatif de l'onde incidente $v_i$ est pris entre le point de connexion C du module de réflectométrie au générateur G et un point médian D de la branche aval du module résistif en $\pi$.

L'application des théorèmes de Thévenin et de superposition et la théorie des lignes permettent en effet d'écrire:

$$v_i = \frac{E}{6} \qquad (20)$$

$$v_A = v_t = v_i + v_r \qquad (21)$$

$$v_B = \frac{E}{6} + \frac{v_r}{9} = v_i + \frac{v_r}{9} \qquad (22)$$

$$v_A - v_B = \frac{8}{9} v_r \qquad (23)$$

$$v_C - v_D = (3 \, v_i - \frac{v_r}{3}) - \frac{(v_i + v_r)}{3} = \frac{8v_i}{3} \qquad (24)$$

La branche de détection du module de l'onde réfléchie $v_r$ comprend en série entre les points A et B, une diode $D_2$ dont l'anode est reliée au point A et une résistance $R_8$ connectée au point B.

Plus précisément, la détection du module de l'onde réfléchie $v_r$ est opérée au niveau du point médian de la branche de détection précitée commun à la diode $D_2$ et à la résistance $R_8$, par l'intermédiaire d'une self $L_2$.

De façon similaire, la branche de détection du module de l'onde incidente $v_i$ comprend, connectée entre les points C et D, une branche série comprenant une diode $D_1$ dont l'anode est connectée au point C et une résistance $R_9$ connectée au point D.

Plus précisément, le module de l'onde $v_i$ est détecté au point médian de la branche de détection précitée, commun à la diode $D_1$ et à la résistance $R_9$ par l'intermédiaire d'une self de liaison $L_3$.

Des selfs inductance $L_1$, $L_4$ sont connectées en parallèle des résistances $R_4$, $R_6$ pour assurer une référence à la masse des signaux continus détectés. Ces selfs $L_1$, $L_4$ à la pulsation la plus faible $\omega_m = 2\pi \, 10^6$ doivent constituer une impédance négligeable ne perturbant pas le fonctionnement du module de réflectométrie. Cette condition est assurée avec des selfs $L_1$, $L_4$ présentant une inductance $L = 1$ mH.

De même, les selfs $L_2$ et $L_3$ ont pour but de transmettre au pré-amplificateur continu les signaux détectés tout en découplant du réseau les capacités parasites des liaisons et des entrées d'amplificateur. Des valeurs de 1 mH conviennent également.

On remarquera également sur la droite de la figure 6, une branche de détection du module de la tension totale en entrée de ligne $v_t$ définie précédemment à la relation (13).

Cette branche de détection comprend, connectée en série, entre le point A précité et la masse, une diode $D_3$ dont l'anode est connectée au point A et une résistance $R_{10}$ connectée à la masse.

Le module de la tension $v_t$ est prélevé au point médian de la branche de détection $D_3$—$R_{10}$ commun à la diode $D_3$ et à la résistance $R_{10}$ par l'intermédiaire d'une self $L_5$ présentant par exemple une inductance de 1 mH.

Le module de réflectométrie qui vient d'être décrit, en particulier les éléments résistants et les diodes composant celui-ci, peuvent être aisément réalisés grâce aux techniques classiques d'intégration de circuit.

Dans le cas où les préamplis continus ne sont pas intégrés au circuit, les points d'accès A, B, C et D, la masse M ainsi que les points E et F doivent être réservés.

Par contre, dans le cas où les préamplis continus sont intégrés au circuit, les points A, B, C, D, la masse M et les sorties des préamplis doivent être réservés.

La réalisation du module de réflectométrie selon les techniques classiques d'intégration de circuit avec adjustage laser des résistances couche mince permet la réalisation de résistances précises et dont les capacités parasites et selfs inductances parasites sont très faibles en raison de leur faibles dimensions.

La connaissance de $v_i$ et $v_r$ permet de déterminer $\Gamma$ et Y sur la base des relations (10), (11) et (12) précitées.

## STRUCTURE DU GENERATEUR A COMMUTATION DE BANDE

Les inventeurs ont développé un oscillateur à fréquence variable sur la gamme V.H.F. (1 à 200 MHz), utilisant une commutation automatique rapide de bandes de fréquence, de réalisation simple et économique.

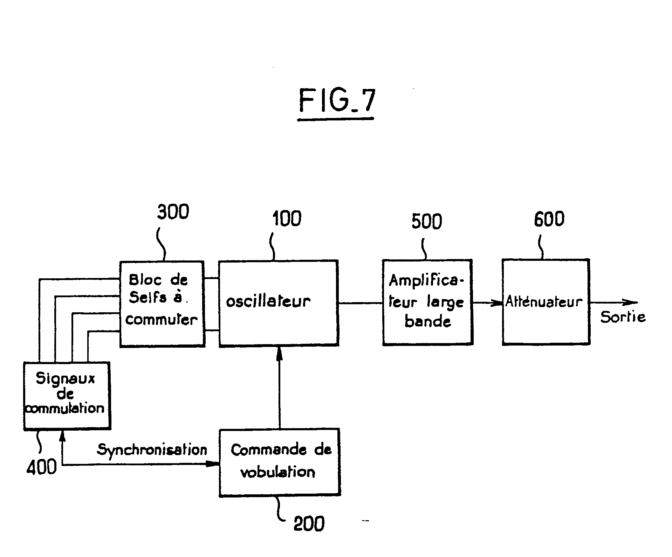

Le schéma général de ce générateur est illustré sur la figure 7.

Pour l'essentiel, ce générateur comprend un oscillateur 100 associé à des moyens 200 de commande de vobulation, et à un bloc de selfs 300 commutées alternativement par un générateur 400 de signaux de commutation synchronisés sur les moyens de commande de vobulation 200.

Par ailleurs, le générateur comprend un ampli large bande 500 connecté en sortie de l'oscillateur et qui attaque un atténuateur 600 dont la sortie constitue la sortie du générateur.

L'oscillateur 100 commandé en tension peut être à éléments intégrés ou discrets.

Le système de commutation de selfs 300—400 permet la couverture d'une assez large bande de fréquence.

La synchronisation des signaux de vobulation issue des moyens 200 et de commutation issus des moyens 400 permet d'assurer un balayage monotone de la bande de fréquence à couvrir.

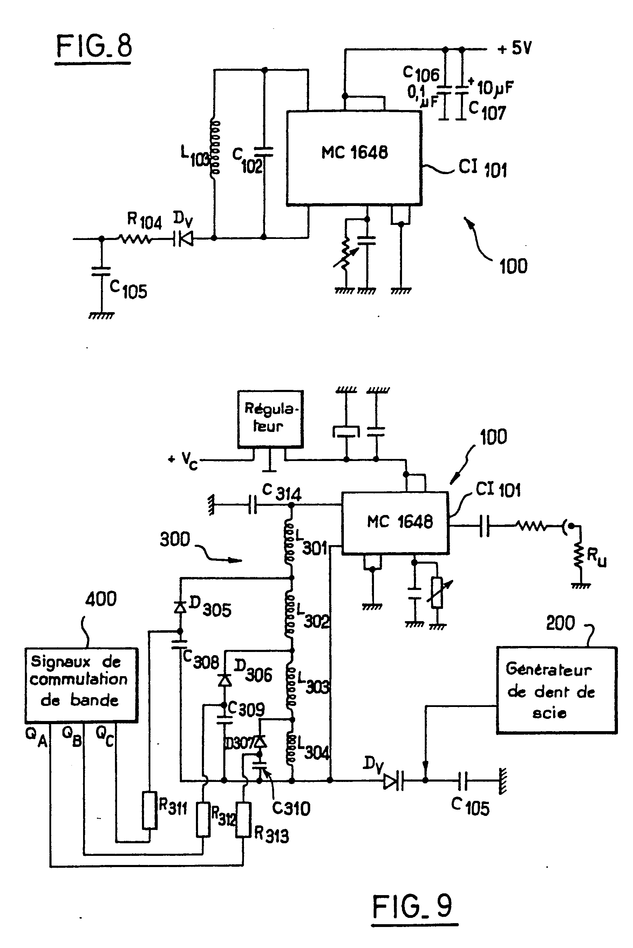

Un mode de réalisation avantageux de l'oscillateur 100 est illustré sur la figure 8.

Cet oscillateur 100 comprend un circuit intégré MC 1648.

Le circuit MC 1648 est un oscillateur en technologie E.C.L.

Il fonctionne avec un circuit bouchon externe formé selon l'illustration schématique de la figure 8 d'une cellule comprenant en parallèle une inductance L103 et une capacité C102 associés à une diode à capacité variable $D_v$.

Cette diode à capacité variable $D_v$ permet de transformer l'oscillateur en un oscillateur commandé par tension V.C.O.

Pour cela, l'anode de la diode à capacité variable $D_v$ étant reliée à l'un des pôles du circuit bouchon, la cathode de la diode à capacité variable est reliée à la masse du montage par l'intermédiaire d'une branche série comprenant une capacité $C_{105}$ côté masse et une résistance R104 côté cathode de la diode $D_v$.

Le point médian de la branche précitée commun à la capacité $C_{105}$ et la résistance R104 reçoit un signal variable de polarisation de la diode à capacité variable $D_v$ permettant de contrôler l'oscillateur.

L'alimentation du circuit est filtrée par des capacités C106, C107.

La bande de fréquence que peut couvrir le circuit MC 1648 est déduite de la relation suivante:

$$\frac{f_{max}}{f_{min}} = \frac{\sqrt{C_{Dmax} + C_s}}{\sqrt{C_{Dmin} + C_s}} \qquad (40)$$

avec

$$f = \frac{1}{2\pi \sqrt{L(C_D + C_s)}} \qquad (41)$$

dans lesquelles:

$C_s = C_{ext} + C_{int}$,

$C_{ext}$ représente la capacité shunt externe,

$C_{int}$ représente la capacité shunt du circuit oscillateur (de l'ordre de 6pF),

$C_D$ représente la valeur de la capacité que présente la diode varicap pour une polarisation donnée.

Les signaux de sortie de l'oscillateur 100 sont de forme carrée. Leur excursion crête à crête et les fronts de montée sont déterminés par la tension de commande automatique interne.

Une connexion d'une résistance variable au point "contrôle automatique de gain" peut permettre d'obtenir une onde sinusoïdale en sortie.

Le circuit MC 1648 présente les caractéristiques suivantes:

— une tension d'alimentation unique (+5 V ou −5,2 V),

— une fréquence de répétition pouvant atteindre 200 MHz,

— une excursion de tension de sortie de 800 mV sur haute impédance,

— un rapport cyclique de 50%.

Comme on l'a évoqué précédemment, la couverture de la gamme V.H.F. 1 MHz—200 MHz est réalisée par commutation de selfs composant le circuit résonnant de l'oscillateur 100.

Cette disposition est illustrée sur la figure 9.

Plus précisement, comme cela est illustré sur cette figure 9, le circuit bouchon de l'oscillateur 100 est formé en combinaison de quatre selfs L301, L302, L303 et L304, associées à des capacités C308, C309, C310 et C314 et à une diode à capacité variable $D_v$.

Les quatre selfs L301, L302, L303 et L304 sont connectées en série.

Le capacité C314 est connectée entre l'un des pôles du circuit bouchon et la masse.

La capacité C308 est connectée en parallèle des selfs L302, L303 et L304 par l'intermédiaire d'une diode $D_{305}$.

La capacité C309 est reliée en paralléle des selfs L303 et L304 par l'intermédiaire d'une diode $D_{306}$.

Enfin, la capacité C310 est reliée en parallèle de la self L304 par l'intermédiaire d'une diode $D_{307}$.

Plus précisément, la cathode de la diode $D_{305}$ est reliée au point commun aux selfs L301 et L302. La cathode de la diode $D_{306}$ est reliée au point commun à la self L302 et L303. Enfin, la cathode de la diode $D_{307}$ est reliée au point commun à la self L303 et L304.

Le générateur de signaux de commutation de bande 400 attaque par sa sortie $Q_C$ et par l'intermédiaire d'une résistance R311 le point commun à l'anode de la diode $D_{305}$ et à la capacité C308. Le même générateur 400 de signaux de commutation de bande attaque par sa sortie $Q_B$ et par l'intermédiaire d'une résistance R312 le point commun à l'anode de la diode $D_{306}$ et à la capacité C309. Enfin, le générateur 400 de signaux de commutation de bande attaque par sa sortie $Q_A$ et par l'intermédiaire d'une résistance R313 le point commun à la diode $D_{307}$ et à la capacité C310.

Par ailleurs, comme cela est représenté sur la figure 9, le générateur polarisant la diode varicap $D_v$ pour assurer la vobulation à l'intérieur de chaque bande de fréquence de l'oscillateur est avantageusement un générateur de dents de scie 200.

Le principe de commutation des selfs L301, L302, L303 et L304 est le suivant.

Au départ, le circuit oscillant est constitué par les quatre selfs L301, L302, L303 et L304 montées en série et la diode varicap $D_v$. Cette dernière est polarisée par un signal provenant du générateur de signaux en dents de scie 200 permettant ainsi la vobulation d'une première bande de fréquence $\Delta f_1$.

La validation de la sortie $Q_A$ du générateur 400 de signaux de commutation de bande cour-circuite la self L304 ce qui permet de réduire la self globale chargeant le circuit oscillant et ainsi d'augmenter sa fréquence de résonnance.

La dent de scie appliquée à l'anode de la diode à capacité variable $D_v$ assure la vobulation de la seconde plage de fréquences $\Delta f_2$.

De même, les selfs L303 et L302 sont successivement court-circuitées par la validation des sorties $Q_B$ et $Q_C$ du générateur 400 de signaux de commutation de bande pour obtenir des bandes supérieures $\Delta f_3$ et $\Delta f_4$ couvertes par la polarisation en dents de scie, issue du générateur 200, de la diode à capacité variable $D_v$.

Dans la pratique, on a constaté qu'il n'est pas nécessaire que les plages de fréquences $\Delta f_1$, $\Delta_2$, $\Delta f_3$ et $\Delta f_4$ obtenues par commutation coïncident exactement. En d'autres termes, on peut tolérer un léger vide entre les domaines de fréquences $\Delta f_1$, ce qui permet de limiter le nombre de selfs à commuter.

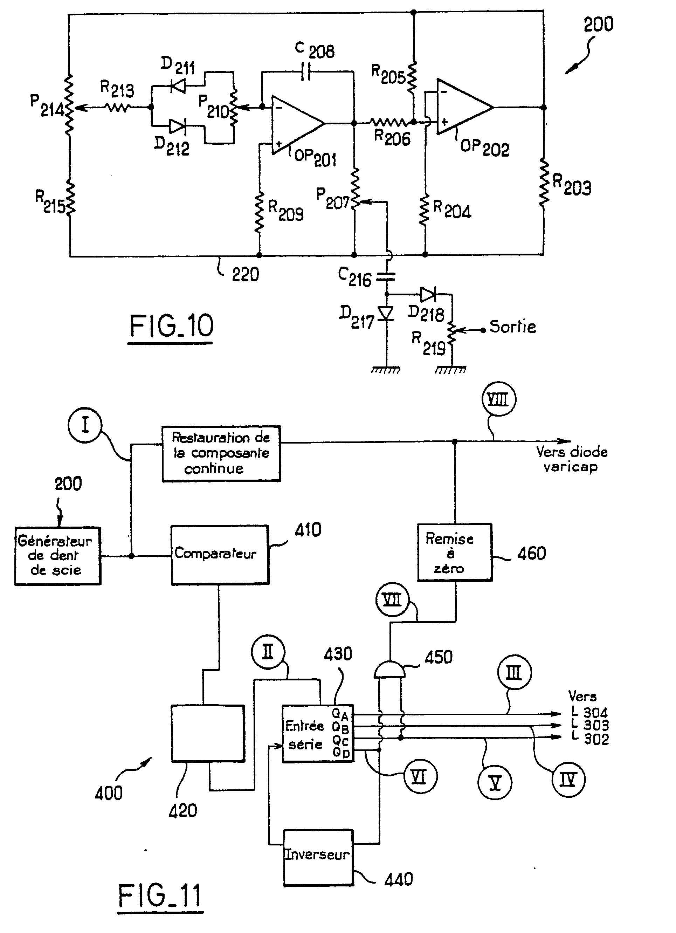

On a représenté sur la figure 10 la structure d'un générateur de dents de scie 200 susceptible d'être utilisé dans le cadre de la présente invention.

Ce générateur de dents de scie 200 est constitué par l'assemblage d'un intégrateur utilisant un amplificateur opérationnel OP201 et d'un comparateur utilisant un amplificateur opérationnel OP202.

La sortie de l'intégrateur constituée par la sortie de l'amplificateur opérationnel OP201 qui fournit une rampe linéaire sert de commande au comparateur, et pour cela est reliée par l'intermédiaire d'une résistance R206 à l'entrée non inverseuse de l'amplificateur opérationnel OP202.

Cette même entrée non inverseuse de l'amplificateur opérationnel OP202 est reliée à sa sortie par l'intermédiaire d'une résistance R205.

Par ailleurs, l'entrée inverseuse de l'amplificateur opérationnel OP202 est reliée à une ligne de base 220 par l'intermédiaire d'une résistance R204. La sortie de l'amplificateur opérationnel OP202 est également reliée à la ligne de base par l'intermédiaire d'une résistance R203.

Le signal obtenu en sortie de l'amplificateur opérationnel OP202 monté en comparateur et provenant de sa saturation haute et basse est envoyé à l'entrée de l'intégrateur.

Plus précisément, la sortie de l'amplificateur operationnel OP202 est reliée à une première à une première borne principale d'un potentiomètre P214 dont la seconde borne principale est reliée à la ligne de base 220 précitée par l'intermédiaire d'une résistance R215.

L'entrée inverseuse de l'amplificateur opérationnel OP201 est reliée au curseur d'un potentiomètre P210.

Les deux bornes principales du potentiomètre P210 sont reliées respectivement à l'anode d'une diode D211 et à la cathode d'une diode D212.

Par ailleurs, la cathode de la diode D211 et l'anode de la diode D212 sont reliées en commun à une première borne d'une résistance R213.

La seconde borne de la résistance R213 est reliée au curseur du potentiomètre P214 precite.

Une capacité C208 relie l'entrée inverseuse de l'amplicateur opérationnel OP201 à sa sortie.

L'entrée non inverseuse de l'amplificateur opérationnel OP201 est reliée à la ligne de base 220 précitée par l'intermediaire d'une résistance R209.

La fréquence de récurrence du signal en dents de scie obtenue en sortie de l'intégrateur OP201 est déterminée par le condenseur C208 et le potentiomètre P214.

Le réglage du temps de retour est assuré par le système de diodes D211, D212 et le potentiomètre P210.

Le signal en dents de scie est prélevé au niveau d'un potentiomètre P207 connecté entre la sortie de l'amplificateur opérationnel OP201 et la ligne de base 220.

Plus précisément, le curseur du potentiomètre P207 est relié à la masse par l'intermédiaire d'une branche comprenant en série une capacité C216 côté curseur du potentiométre P207 et une diode D217 dont l'anode est connectée à la masse.

Par ailleurs, une autre branche série comprenant une diode D218 et un potentiomètre P219 est connectée en parallèle de la diode D217.

L'anode de la diode D218 est reliée à la cathode de la diode D217 et la cathode de la diode D218 est reliée à la masse par l'intermédiaire du potentiomètre P219.

Le curseur de ce dernier constitue la sortie du générateur de dents de scie 200 attaquant la diode à capacité variable $D_v$ pour polariser celle-ci.

Les diodes D217, D218 et le condensateur C216 permettent de restituer la composante continue, le signal de sortie étant à polarité positive.

Selon une caractéristique importante de la présente invention, pour arriver à un synchronisation parfait entre la commutation des selfs L302, L303 et L304 et la commande de vobulation issue du générateur de dents de scie 200, ce dernier est utilisé comme pilote pour générer les signaux de commutation.

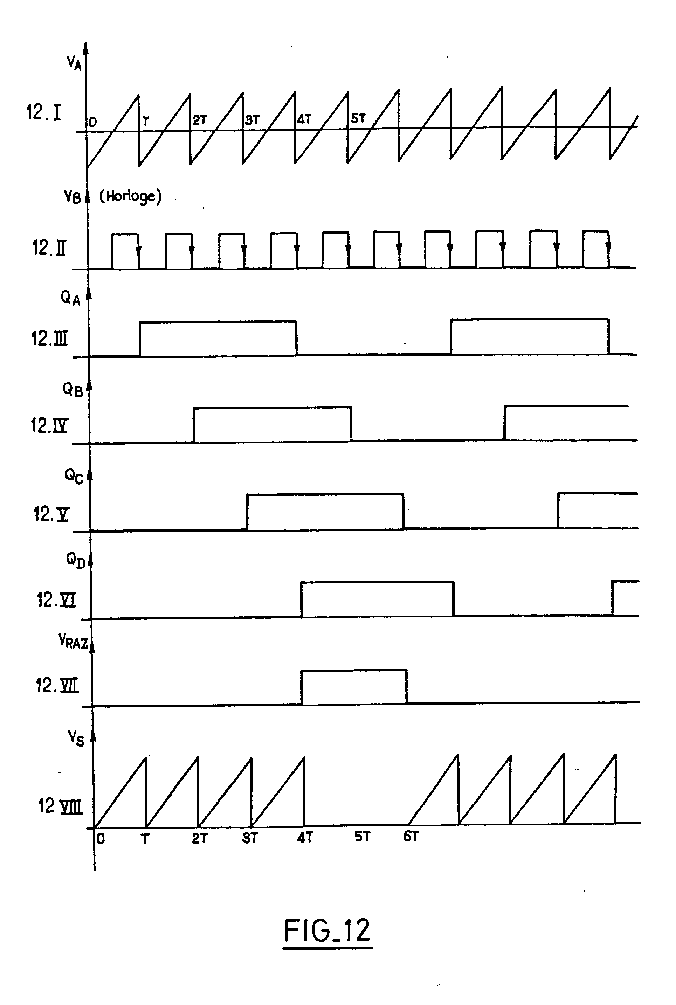

Comme illustré sur la figure 11, un comparateur 410 de seuil nul est excité par les ondes en forme de dents de scie issues du générateur 200, et génère à sa sortie les signaux relatifs à la saturation haute et basse.

Un étage tampon 420 connecté en sortie du comparateur 410 adapte ses états au niveau de la logique TTL et génère en sortie un signal d'horloge assurant le séquencement de la commutation des selfs L302, L303 et L304.

Pour cela, le signal d'horloge issu de l'étage tampon 420 attaque un registre à décalage 430, à entrée série et à sorties parallèles.

Les trois premières sorties $Q_A$, $Q_B$ et $Q_C$ du registre à décalage 400 assurent la commutation des selfs L302, L303 et L304, comme indiqué précédemment en regard de la figure 10.

La quatrième sortie $Q_D$ du registre à décalage 430 rebouclée sur une entrée de commande de celui-ci par l'intermédiaire d'un inverseur 440 permet de contrôler le déroulement recherché du cycle de commutation.

Par ailleurs, les sorties $Q_D$ et $Q_C$ du registre à décalage 430 assurent la remise à zéro du système de vobulation.

Pour cela, les sorties $Q_D$ et $Q_C$ sont reliées respectivement aux entrées d'une porte ET 450 qui attaquent une cellule de remise à zéro 460 reliée à la diode à capacité variable $D_v$.

L'homme de l'art comprendra aisément le fonctionnement du générateur qui vient d'être décrit en regard du chromogramme illustré sur la figure 12.

La première ligne 12.I de la figure 12 illustre le signal en dents de scie issu du générateur 200.

La seconde ligne 12.II de la figure 12 illustre le signal d'horloge appliqué au registre à décalage 430.

Les troisième, quatrième, cinquième et sixième lignes 12.III, 12.IV, 12.V et 12.VI de la figure 12 illustrent respectivement les sorties $Q_A$, $Q_B$, $Q_C$ et $Q_D$ du registre à décalage 430.

La septième ligne 12.VII de la figure 12 illustre le signal de remise à zéro issu de la porte ET 450.

Enfin, la huitième ligne 12. VIII de la figure 12 illustre le signal de polarisation appliqué sur la diode à capacité variable $D_v$.

On comprend à l'examen de la figure 12 que — pour $0 < t < T$, toutes les selfs L301, L302, L303 et L304 sont actives et la dent de scie de durée T issue du générateur 200 permet d'obtenir un signal dont la fréquence couvre une plage $\Delta f_1$ due à la polarisation variable de la diode $D_v$.

— Pour $T < t < 2T$, la sortie $Q_A$ du registre à décalage 430 est à l'état haut, ce qui polarise la diode D307 dans le sens direct et permet de court-circuiter la self L304. Le circuit oscillant n'est plus formé que des selfs

**EP 0 211 711 B1**

L301, L302, L303 et de la diode varicap $D_v$. On a ainsi assuré une commutation de fréquence dans la plage supérieure $\Delta f_2$. Là encore, la dent de scie de durée T polarisant la diode $D_v$ permet de couvrir la plage de fréquences $\Delta f_2$.

— Pour $2T < t < 3T$, la sortie $Q_B$ du registre à décalage 430 est à l'état haut ce que permet de polariser la diode D306 dans le sens direct et de court-circuiter la self L303. Le circuit oscillant n'est alors formé que des selfs L301, L302 et de la diode à capacité variable $D_v$ pour obtenir un décalage dans le domaine de fréquence $\Delta f_3$ couvert par la polarisation variable de la diode $D_v$ du signal en dents de scie de période T.

— Pour $3T < t < 4T$, la diode D305 est polarisée dans le sens direct par les passages à l'état haut de la sortie $Q_C$ du registre à décalage ainsi, seules la self L301 et la diode à capacité variable $D_v$ forment le circuit résonant pour obtenir une commutation dans le domaine de fréquence supérieur $\Delta f_4$ couvert par la diode varicap $D_v$.

On a ainsi obtenu une couverture totale de la bande de fréquence désirée.

Une réinitialisation doit être effectuée automatiquement à la fin du cycle. Pour cela, on bloque l'envoi de signaux sur la diode varicap $D_v$ par une remise à zéro du signal de commande de cette dernière grâce à la porte ET 450 et à la cellule 460 précitées.

UTILISATION DES RESULTATS DE MESURE POUR L'ANALYSE DES DIPOLES

Deux cas doivent être considérés.

Dans le premier cas, le module de réflectométrie permet d'obtenir tout d'abord à une fréquence ou pulsation donnée, $|v_t|$, $|v_i|$ et $|v_r|$.

On dispose ainsi directement du module $|v_r/v_i|$ et après calcul, de l'argument $\varphi$ de $v_r/v_i$ obtenu grâce à la relation (13 bis).

$Y(j\omega)$ est ensuite déterminée par la relation (10). Son obtention ne nécessite aucune hypothèse de départ sur la structure interne du dipôle.

Dans le second cas, on maintient $|(v_i(\omega)|$ constant et on mesure uniquement $|v_r(\omega)|$. Dans ce cas, il faut faire la mesure sur une gamme étendue de pulsations et disposer d'un modèle paramètrique (schéma de Foster d'un condensateur imparfait) dont on détermine les paramètres.

CAS DU RECOUVREMENT DES BRANCHES ACTIVES DU DIPOLE

Dans l'expression:

$$\Gamma\,(j\omega) \;=\; j \;+\; \frac{\Gamma_{j-1} \;-\; \Gamma_j}{1 \;+\; jT_j\omega} \tag{17}$$

$\Gamma_{j-1}$ prend en compte toutes les contributions, devenues purement réelles, des branches qui ont été activées lors d'un balayage à pulsation $\omega$ croissante avant d'atteindre la pulsation

$$\omega_j = \frac{1}{T_j}$$

et $\Gamma_j$ est la valeur réelle qu'atteindra $\Gamma(j\omega)$ lorsque $\omega$ dépassant $\omega_j$ la branche j cessera d'être active.

L'expression;

$$G_{(j\omega)} \;=\; \frac{\Gamma_{j-1} \;-\; \Gamma_j}{1 \;+\; j\,T_j\,\omega} \tag{42}$$

peut donc être considérée comme l'expression du domaine de variation de la branche j. L'"amplitude" Aj de ce domaine est la quantité $\Gamma_{j-1} - \Gamma_j$, on peut écrire

$$|G| = \frac{Aj}{1 \;+\; T_j^{\,2}\omega^2} \;=\; \frac{Aj}{1 + \dfrac{\omega^2}{\omega_j^{\,2}}} \tag{43}$$

On peut définir le domaine fréquentiel de variation de la branche j par l'intervalle $\omega_{Bj}$, $\omega_{Hj}$ avec

$$|G| = A_j\,(1-0{,}1)\ \text{pour}\ \omega_{Bj}\ \text{ce qui donne} \tag{44}$$

13

$$\omega_{Bj} = \frac{1}{\sqrt{10}} \quad \omega_j \qquad et \qquad\qquad (45)$$

$$|G| = A_j \times 0,1 \quad pour \quad \omega_{Hj} \quad soit \qquad\qquad (46)$$

$$\omega_{Hj} = \sqrt{10} \; \omega_j \qquad\qquad (47)$$

On obtient donc $\dfrac{\omega_{Hj}}{\omega_{Bj}} = 10$

Le domaine de variation d'une branche j s'étend donc sur une décade de fréquence. En dehors de cet intervalle, le module de G différe de moins de 10% de ses valeurs asymptotiques.

Cet intervalle vaut toujours une décade et est indépendant de l'amplitude $A_j$.

Dès lors, si l'intervalle fréquentiel mesuré entre 2 paliers successifs de la courbe $|\Gamma(\omega)|$ à partir des repères à 10% de l'amplitude $A_j$ séparant les paliers, est supérieur à 1 décade, c'est qu'il y a recouvrement de branches actives.

$A_j$ peut alors être considéré comme la somme des amplitudes $A_1$, $A_2$ ... des branches actives en recouvrement, mais le recouvrement a pour effet de réduite l'intervalle fréquentiel qui, pour deux branches par exemple, sera compris entre 1 décade et 2 décades.

L'expression du coefficient de réflexion devient:

$$\Gamma(\omega) = \Gamma + \frac{A_1}{1 + jT_1\omega} + \frac{A_z}{1 + jT_2\omega} \quad avec \; : \qquad (48)$$

$$T_1 = \frac{1}{\omega_1} \qquad T_2 = \frac{1}{\omega_2} \; ; \quad \omega_1 < \omega_2 < 10\omega_1$$

Les deux domaines présentent donc une zone où ils sont "actifs" simultanément. Cependant, à pulsation croissante le domaine $A_1$ est le premier actif et, pour les pulsations $\omega$ faibles proches du début du domaine global de variation, on peut écrire:

$$\Gamma(\omega) = \Gamma + A_2 + \frac{A_1}{1 + T_1^2\omega^2} - \frac{j \, A_1 \, T_1 \, \omega}{1 + T_1^2 \, \omega^2} \qquad (49)$$

ou encore, avec $T_1\omega \ll 1$ :

$$\Gamma(\omega) = \Gamma + A_2 + A_1 - A_1 \, T_1^2 \, \omega^2 - j \, A_1 \, T_1 \, \omega \quad soit \qquad (50)$$

$$|\Gamma(\omega)| = \left[ (\Gamma + A_2 + A_1)^2 \left( 1 - \frac{2A_1 \, T_1^2 \, \omega^2}{\Gamma + A_2 + A_1} \right) + A_1^2 \, T_1^2 \, \omega^2 \right]^{1/2} \qquad (51)$$

ou

$$|\Gamma(\omega)| = (\Gamma + A_2 + A_1) \left( 1 - \left[ \frac{A_1}{\Gamma + A_2 + A_1} - \frac{A^2}{2(\Gamma + A_2 + A_1)^2} \right] T_1^2 \, \omega^2 \right) \qquad (52)$$

qu'on peut écrire

$$\log|\Gamma(\omega)| = \log(\Gamma + A_2 + A_1) - \left[ \frac{A_1}{\Gamma + A_2 + A_1} - \frac{1}{2} \frac{A_1^2}{(\Gamma + A_2 + A_1)^2} \right] \frac{\omega^2}{\omega_1^2} \qquad (53)$$

relation linéaire entre $\log |\Gamma(\omega)|$ et $\omega^2$.

La pente de cette droite s'écrit

$$P_1 = -\left[\frac{A_1}{\Gamma+A_2+A_1}\left(1 - \frac{1}{2}\frac{A_1}{\Gamma+A_2+A_1}\right)\right]\frac{1}{\omega_1^2} \qquad (54)$$

De même, pour les pulsations $\omega$ élevées proches de la fin du domaine de variation global, seul le domaine 2 reste actif mais son comportement se réduit à un terme

$$\frac{A_2}{jT_2\omega} \qquad \text{on peut encore écrire}$$

$$\Gamma(\omega) = \Gamma + \frac{A_2}{jT_2\omega} = \Gamma - j\frac{A_2}{T_2\ \omega} \qquad (55)$$

et

$$|\Gamma(\omega)| = \Gamma\left(1 + \frac{A_2^2}{2\Gamma^2 T_2^2\omega^2}\right) \qquad (56) \quad \text{d'où}$$

$$\log|\Gamma(\omega)| = \log \Gamma + \frac{A_2^2\ \omega_2^2}{2\Gamma^2}\ x\frac{1}{\omega^2} \qquad (57; \quad \text{d'où une pente}$$

$$P_2 = \frac{A_2^2\ \omega_2^2}{2\Gamma_2^2} \qquad (58) \quad \text{pour la droite } \log|\Gamma(\omega)| = f\left(\frac{1}{\omega^2}\right)$$

Enfin, dans la région centrale, pour $\omega_1 < \omega < \omega_e$; on est relativement proche pour les deux domaines, des conditions

$$\frac{\omega}{\omega_1} = 1 \quad \text{et } \frac{\omega}{\omega_2} = 1.$$

Posons, pour le premier domaine $\omega = \omega_1 + x$, soit $x = \omega - \omega_1$ avec $x \ll \omega_1$, on obtient:

$$\frac{A_1}{1+jT_1\ \omega} = \frac{A_1}{1+j\frac{\omega}{\omega_1}} = \frac{A_1}{1+j+j\frac{x}{\omega_1}} = \frac{A_1\left[1-j\left(1+\frac{x}{\omega_1}\right)\right]}{2\left(1+\frac{x}{\omega_1}\right)} \qquad (59)$$

$$\frac{A_1}{1+j\frac{\omega}{\omega_1}} \cong \frac{A_1}{2}\left[\frac{1}{1+\frac{x}{\omega_1}} - j\right] \cong \frac{A_1}{2}\left[\frac{\omega_1}{\omega} - j\right] \qquad (60)$$

Si on suit la même procédure pour le domaine 2, on trouve:

$$\frac{A_2}{1+j\frac{\omega}{\omega_2}} \cong \frac{A_2}{2}\left[\frac{\omega_2}{\omega} - j\right] \qquad (61) \quad \text{d'où}$$

15

$$|\Gamma(\omega)| = \left[\left(\Gamma + \left[\frac{A_1 \omega_1 + A_2 \omega_2}{2\omega}\right]\right)^2 + \left(\frac{A_1 + A_2}{2}\right)^2\right]^{1/2} \quad (62)$$

$$= \left(\frac{A_1 + A_2}{2}\right)\left[1 + \left(\frac{2\Gamma}{A_1 + A_2} + \frac{A_1\omega_1 + A_2\omega_2}{A_1 + A_2} \times \frac{1}{\omega}\right)^2\right]^{1/2}$$

Posons (63) $\omega_M = \dfrac{A_1\omega_1 + A_2\omega_2}{A_1 + A_2}$ on obtient :

$$|\Gamma(\omega_M)| = \left[\left(\frac{A_1 + A_2}{2}\right)^2 + \left(\Gamma + \frac{A_1 + A_2}{2}\right)^2\right]^{1/2}$$

Sur la courbe $\Gamma(\omega)|$ on cherche la valeur $|\Gamma(\omega_M)|$ qu'on détermine par la formule ci-dessus dans laquelle $\Gamma$ est connu ainsi que $A_1 + A_2 = A$ amplitude du domaine global. La pulsation $\omega_M$ correspondant à la valeur définie ci-dessous, on dispose, à présent pour déterminer A, $A_2$, $\omega_1$ $\omega_2$ de quatre équations:

$$A_1 + A_2 = A \quad (65)$$

$$A_1 \omega_1 + A_2 \omega_2 = A\omega_M \quad (66)$$

$$P_1 = -\left[\frac{A_1}{\Gamma + A_2 + A_1}\left(1 - \frac{1}{2}\frac{A_1}{\Gamma + A_2 + A_1}\right)\right]\frac{1}{\omega_1^2} \quad (54)$$

$$P_2 = \frac{A_2^2 \omega_2^2}{2\Gamma^2} \quad (58)$$

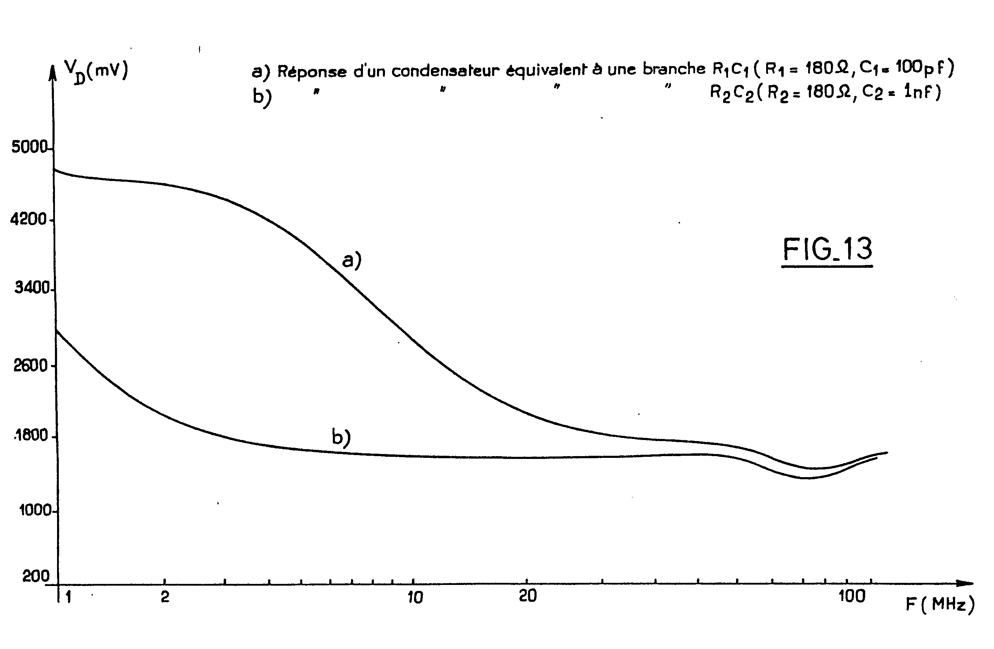

La figure 13 montre en courbe a) la réponse d'un condensateur équivalent à une branche $R_1C_1$ avec $R_1 = 180\ \Omega$ et $C_1 = 100$ pf et en courbe b) la réponse d'un condensateur équivalent à une branche $R_2C_2$ avec $R_2 = 180\ \Omega$, $C_2 = 1$ nf.

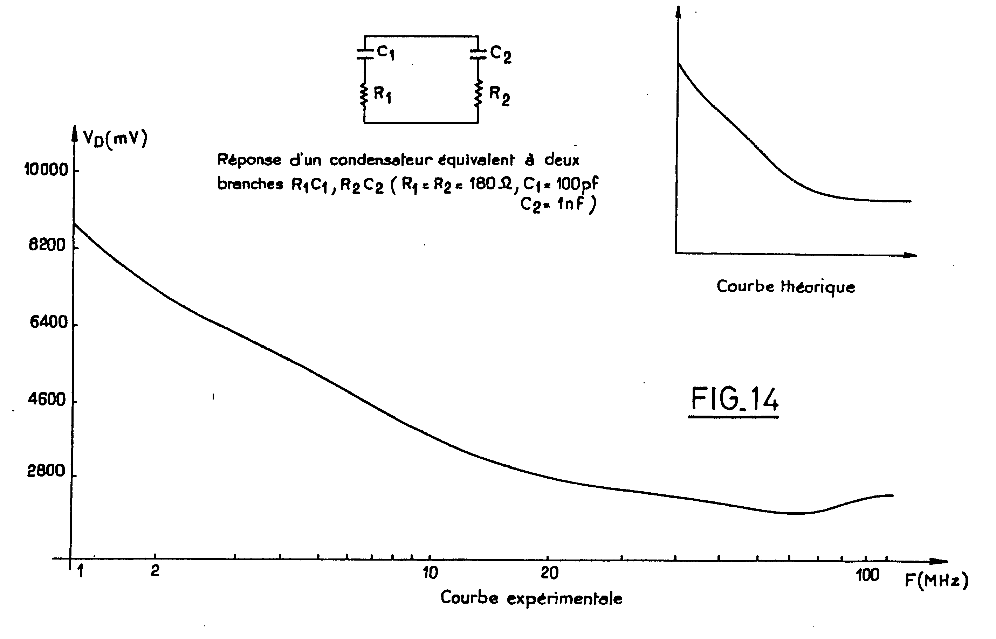

La figure 14 représente d'une part la courbe expérimentale, d'autre part la courbe théorique de la réponse d'un condensateur équivalent à deux branches $R_1C_1$, $R_2C_2$ avec $R_1 = R_2 = 180\ \Omega$, $C_1 = 100$ pf, $C_2 = 1$ nf.

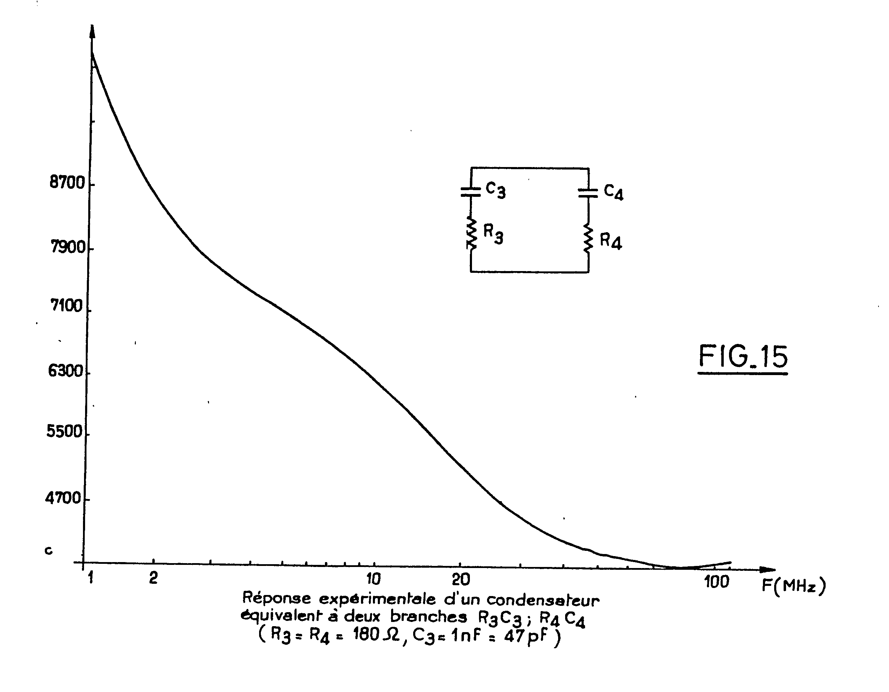

La figure 15 représente la réponse expérimentale d'un condensateur équivalent à deux branches $R_3C_3$, $R_4C_4$ avec $R_3 = R_4 = 180\ \Omega$, $C_3 = 1$ nf, $C_4 = 47$ pf. .

Sur les figures 13, 14, 15, $V_D$ représente la tension réfléchie détectée.

On a donc $V_D$ proportionnel à $|v_r|$ et proportionnel $|\Gamma(\omega)|$.

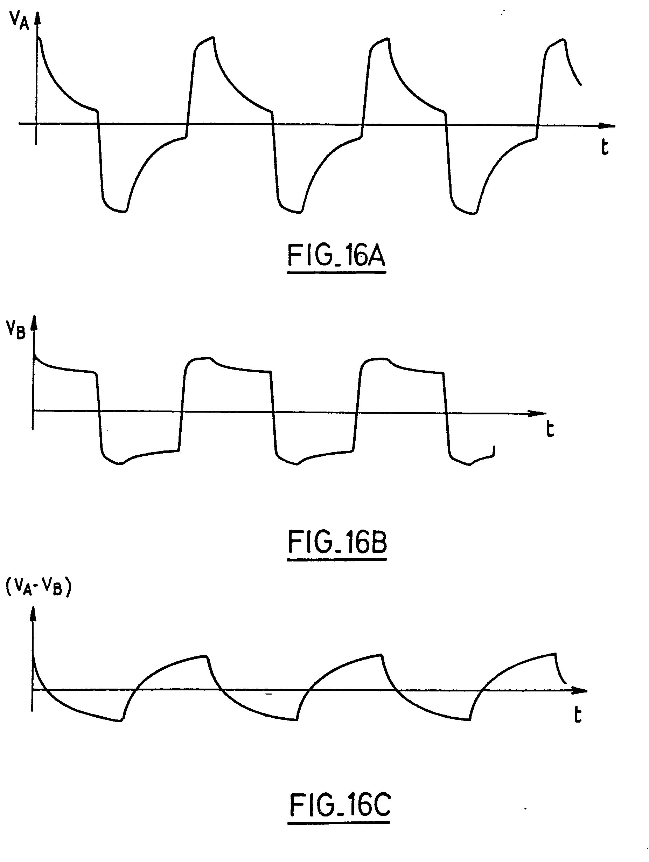

Les figures 16A, 16B et 16C représentent respectivement la tension mesurée au point A du module de réflectométrie précédemment décrit, la tension mesurée au point B, et la tension mesurée entre les points A et B.

**Revendications**

1. Procédé de test rapide, dans la gamme V.H.F., de dipôles passifs, comprenant les étapes consistant à:

i) connecter un générateur (G) de signal électrique de fréquence située dans la gamme V.H.F. en tête d'une ligne (L) et à connecter le dipôle à tester (Y) à l'autre extrémité de la ligne (L), sous forme d'impédance terminale,

ii) alimenter la ligne (L), grâce au générateur (G), par une onde incidente $v_i$ périodique dont la fréquence est modulable dans la gamme V.H.F. pendant la durée du test,

iii) détecter, en tête de ligne (L), un premier signal représentatif de l'onde réfléchie $v_r$ et un second signal représentatif de l'onde incidente $v_i$ grâce à un module intercalé entre le générateur (G) et la ligne (L), pour définir l'évolution du coefficient de réflexion $\Gamma$ sur la gamme V.H.F. et déterminer de ce coefficient de

EP 0 211 711 B1

réflexion Γ l'impédance du dipôle à tester (Y), caractérisé par le fait que:

— la ligne (L) est constituée d'une ligne à constantes réparties présentant une impédance caractéristique $R_c$ égale à l'impédance interne du générateur (G),

— le module intercalé entre le générateur (G) et la ligne (L) est formé d'un réseau résistif en π comprenant une borne d'entrée (C) destinée à être raccordée à la sortie du générateur (G) et une borne de sortie (A) destinée à être raccordée à la ligne (L), et le module est constitué:

. d'une première branche comprenant une première et une deuxième résistances ($R_3$, $R_4$) connectées en série entre la borne d'entrée (C) et la masse, et un premier point médian de sortie (B) situé entre ces deux résistances ($R_3$, $R_4$) dans laquelle la première résistance ($R_4$) de cette première branche, située entre la masse et le premier point médian de sortie (B) a une valeur égale aux 2/3 de l'impédance caractéristique $R_c$ de la ligne (L), tandis que la deuxième résistance ($R_3$) de cette première branche, située entre la borne d'entrée (C) et le premier point médian de sortie (B) a une valeur égale aux 4/3 de l'impédance caractéristique $R_c$ de la ligne (L),

. d'une deuxième branche comprenant une première et une deuxième résistances ($R_5$, $R_6$) connectées en série entre la borne de sortie (A) et la masse, et un deuxième point médian de sortie (D) situé entre ces deux résistances ($R_5$, $R_6$), dans laquelle la première résistance ($R_6$) de cette deuxième branche, située entre la masse et le deuxième point médian de sortie (D) a une valeur égale aux 2/3 de l'impédance caractéristique $R_c$ de la ligne (L) tandis que la deuxième résistance ($R_5$) de cette deuxième branche, située entre la borne de sortie (D) et le deuxième point médian de sortie (A) a une valeur égale aux 4/3 de l'impédance caractéristique $R_c$ de la ligne (L), et

. d'une troisième branche comprenant une résistance ($R_2$) connectée entre la borne d'entrée (C) et la borne de sortie (A), et qui a une valeur égale aux 4/3 de l'impédance caractéristique $R_c$ de la ligne (L), et comprenant les étapes consistant à:

— mesurer un premier signal représentatif de l'onde réfléchie Vr, entre la borne de sortie (A) et le premier point médian de sortie (B) prévu sur la première branche, et

— mesurer un second signal représentatif de l'onde incidente Vi, entre la borne d'entrée (C) et le deuxième point médian de sortie (D) prévu sur la deuxième branche.

2. Procédé de test rapide selon la revendication 1, caractérisé par le fait qu'à l'étape ii) la ligne (L) est alimentée par une onde incidente $v_i$ périodique dont la période varie sur une gamme de l'ordre de 1 μs à 5 ns sur une durée de test d'environ 1 s.

3. Procédé de test rapide selon l'une des revendications 1 ou 2, caractérisé par le fait qu'au cours de l'étape ii), la ligne (L) est alimentée par une onde incidene $v_i$ dont la période est modulée par vobulation sur la gamme V.H.F. selon une fonction linéaire ou logarithmique du temps.

4. Procédé de test rapide selon l'une des revendications 1 à 3 pour l'analyse de condensateurs, caractérisé par le fait que, le module d'admittance |Y| du dipôle évoluant comme une suite de paliers de valeurs $G_j$, ceux-ci sont déterminés à l'étape iii) sur la base de la relation:

$$G_j = \frac{1}{R_c} \; \frac{1 - |\Gamma_j|}{1 + |\Gamma_j|}$$

dans laquelle

$R_c$ représente l'impédance caractéristique de la ligne (L) et

$|\Gamma_j|$ représente le module du coefficient de réflexion.

5. Procédé de test rapide selon la revendication 4, pour l'analyse de condensateurs sous forme d'un réseau de n branches parallèles comportant chacune en série une résistance $R_j$ et une capacitance $C_j$ caractérisé par le fait que la résistance $R_j$ et la capacitance $C_j$ sont déterminées à l'étape iii) sur la base des relations:

$$1/R_j = G_j - G_{j-1}$$

dans laquelle

$G_j$ et $G_{j-1}$ représentent

deux paliers successifs du module d'admittance |Y|, et

$$C_j = (G_j - G_{j-1})/w_j$$

dans laquelle $\omega_j$ représente la pulsation critique de la branche considérée.

6. Procédé de test rapide selon l'une des revendications 1 à 5, caractérisé par le fait qu'il comprend en outre les étapes consistant à:

— détecter la tension totale $V_c$ entre la masse et la borne de sortie (A) du module résistif en π et

— déterminer l'argument du coefficient de réflexion Γ sur la base de l'équation:

$$\text{arg } \Gamma = 2\beta\ell + \text{arccos } \frac{v_t^2 - v_i^2 - v_r^2}{2|v_r||v_i|}$$

dans laquelle

β représente la constante de phase de la ligne (L) et

l représente la longueur de la ligne (L).

7. Procédé de test rapide selon l'une des revendications 1 à 6, caractérisé par le fait que l'étape ii) est réalisée à l'aide d'un oscillateur (100) à fréquence variable, à commutation automatique de bandes de fréquence.

8. Procédé de test rapide selon la revendication 7, caractérisé par le fait que le circuit bouchon de l'oscillateur (100) est associé à une diode varicap ($D_v$) polarisée par un signal en dents de scie (200) assurant la vobulation à l'intérieur de chaque bande de fréquence, le circuit bouchon de l'oscillateur comportant une pluralité de selfs (L301, L302, L303, L304) progressivement mises en service pour assurer la commutation de bandes de fréquence.

9. Procédé de test rapide selon la revendication 8, caractérisé par le fait que les signaux de commutation de bandes de fréquence (400) assurant progressivement la mise en service des selfs (L301, L302, L303, L304) du circuit bouchon de l'oscillateur sont générés à partir du signal en dents de scie (200) polarisant la diode varicap ($D_v$).

10. Procédé de test rapide selon la revendication 9, caractérisé par le fait que les signaux de commutation de bandes de fréquence sont générés en sortie d'un registre à décalage (430) à entrée série et sorties parallèles commandé par le générateur de signal en dents de scie (200).

11. Dispositif de test rapide, dans la gamme V.H.F., de dipôles passifs pour la mise en oeuvre du procédé selon l'une des revendications 1 à 10, comprenant:

— un générateur (G) de signal électrique de fréquence variable dans la gamme V.H.F.

— une ligne (L) connectée en sortie au dipôle à tester (Y) formant impédance terminale, et en tête audit générateur (G) par l'intermédiaire

— d'un module conçu pour séparer un premier signal représentatif de l'onde réfléchie $v_r$ et un second signal représentatif de l'onde incidente $v_i$ lorsque la ligne (L) est alimentée par une onde incidente $v_i$ périodique dont la fréquence est modulée dans la gamme V.H.F. pendant la durée du test, pour définir l'évolution du coefficient de réflexion Γ sur la gamme V.H.F. et déterminer de ce coefficient de réflexion Γ l'impédance du dipôle à tester (Y), caractérisé par le fait que:

— la ligne (L) est une ligne à constantes réparties présentant une impédance caractéristique $R_c$ égale à l'impédance interne du générateur (G),

— le module intercalé entre le générateur (G) et la ligne (L) est un réseau résistif en π comprenant une borne d'entrée (C) destinée à être raccordée à la sortie du générateur (G) et une borne de sortie (A) destinée à être raccordée à la ligne (L), et le module est constitué:

. d'une première branche comprenant une première et deuxième résistances ($R_3$, $R_4$) connectées en série entre la borne d'entrée (C) et la masse, et un premier point médian de sortie (B) situé entre ces deux résistances ($R_3$, $R_4$), dans laquelle la première résistance ($R_4$) de cette première branche, située entre la masse et le premier point médian de sortie (B) a une valeur égale aux 2/3 de l'impédance caractéristique $R_c$ de la ligne (L), tandis que la deuxième résistance ($R_3$) de cette première branche, situés entre la borne d'entrée (C) et le premier point médian de sortie (B) a une valeur égale aux 4/3 de l'impédance caractéristique $R_c$ de la ligne (L),

. d'une deuxième branche comprenant une première et une deuxième résistances ($R_5$, $R_6$) connectées en série entre la borne de sortie (A) et la masse, et un deuxième point médian de sortie (D) situé entre ces deux résistances ($R_5$, $R_6$), dans laquelle la première résistance ($R_6$) de cette deuxième branche, située entre la masse et le deuxième point médian de sortie (D) a une valeur égale aux 2/3 de l'impédance caractéristique $R_c$ de la ligne (L) tandis que la deuxième résistance ($R_5$) de cette deuxième branche, située entre la borne de sortie (D) et le deuxième point médian de sortie (A) a une valeur égale aux 4/3 de l'impédance caractéristique $R_c$ de la ligne (L), et

. d'une troisième branche comprenant une résistance ($R_2$) connectée entre la borne d'entrée (C) et la borne de sortie (A), et qui a une valeur égale aux 4/3 de l'impédance caractéristique $R_c$ de la ligne (L), et comprenant:

— des moyens aptes à prélever un premier signal représentatif de l'onde réfléchie $V_r$, entre la borne de sortie (A) et le premier point médian de sortie (B) prévu sur la première branche,

— des moyens aptes à prélever un second signal représentatif de l'onde incidente $V_i$ entre la borne d'entrée (C) et le deuxième point médian de sortie (D) prévu sur la deuxième branche, et

— des moyens aptes à former le rapport entre le premier signal et le second signal pour former un signal représentatif du module du coefficient de réflexion $|\Gamma|$.

12. Dispositif de test rapide selon la revendication 11, caractérisé par le fait que le générateur (G) est adapté pour alimenter la ligne (L) par une onde incidente $v_i$ périodique dont la période varie sur une gamme de l'ordre de 1 μs à 5 ns sur une durée de test d'environ 1 s. ..

13. Dispositif de test rapide selon l'une des revendications 11 et 12 pour l'analyse de condensateurs, caractérisé par le fait qu'il comprend des moyens aptes à déterminer les paliers $G_j$ du module d'admittance $|Y|$ du dipôle sur la base de la relation:

$$G_j = \frac{1}{R_c} \frac{1 - |\Gamma_j|}{1 + |\Gamma_j|}$$

dans laquelle:

$R_c$ représente l'impédance caractéristique de la ligne, et

$|\Gamma_j|$ représente le module du coefficient de réflexion.

14. Dispositif de test rapide selon la revendication 13, pour l'analyse de condensateurs, sous forme d'un réseau de n branches parallèles comportant chacune en série une résistance $R_j$ et une capacitance $C_j$, caractérisé par le fait qu'il comprend:

— des moyens aptes à déterminer la résistance $R_j$ sur la base de la relation

$$1/R_j = G_j - G_{j-1}$$

dans laquelle

$G_j$ et $G_{j-1}$ représentent deux paliers successifs du module d'admittance $|Y|$ et

— des moyens aptes à déterminer la capacitance $C_j$ sur la base de la relation

$$C_j = (G_j - G_{j-1})/w_j$$

dans laquelle

$\omega_j$ représente la pulsation critique de la branche considérée.

15. Dispositif de test rapide selon l'une des revendications 11 à 14, caractérisé par le fait qu'il comprend en outre:

— des moyens aptes à détecter la tension totale $V_c$ entre la masse et la borne de sortie (A) du module résistif en $\pi$ et

— des moyens aptes à déterminer l'argument du coefficient de réflexion $\Gamma$ sur la base de l'équation:

$$arg \ \Gamma = 2\beta\ell + arccos \ \frac{V_t^2 - V_i^2 - V_r^2}{2|V_r||V_i|}$$

dans laquelle

$\beta$ représente la constante de phase de la ligne (L) et

$l$ représente la longueur de la ligne (L).

16. Dispositif de test selon l'une des revendications 11 à 15, caractérisé par le fait que le générateur (G) comprend un oscillateur (100) à fréquence variable, à commutation automatique de bandes de fréquence.

17. Dispositif de test selon la revendication 16, caractérisé par le fait qu'il comprend un générateur de signal en dents de scie (200), que le circuit bouchon de l'oscillateur est associé à une diode varicap ($D_v$) polarisée par le signal en dents de scie (200) assurant la vobulation à l'intérieur de chaque bande de fréquence, le circuit bouchon de l'oscillateur comportant une pluralité de selfs (L301, L302, L303, L304) alternativement mises en service pour assurer la commutation de bandes de fréquence.

18. Dispositif de test selon la revendication 17, caractérisé par le fait que le générateur de signal en dents de scie (200) génère également les signaux de commutation (400) de bandes de fréquence assurant alternativement la mise en service des selfs (L301, L302, L303, L304) du circuit bouchon de l'oscillateur.

19. Dispositif de test selon la revendication 18, caractérisé par le fait qu'il comprend un registre à décalage (430) à entrée série et sorties parallèles commandé par le générateur de signal en dents de scie (200) et générant en sortie les signaux de commutation de bandes de fréquence.

**Patentansprüche**

1. Verfahren zur schnellen Prüfung von passiven Zweipolen im VHF-Bereich, umfassend die folgenden Schritte:

i) Anschließen eines elektrischen Signalgenerators (G) mit einer im VHF-Bereich gelegenen Frequenz an den Kopf einer Leitung (L) und Anschließen des zu prüfenden Zweipols (Y) in Gestalt einer Abschlußimpedanz an das andere äußerste Ende der Leitung (L),

ii) Speisen der Leitung (L) aus dem Generator (G) mit einer ankommenden periodischen Welle $v_i$, deren

Frequenz während der Dauer der Prüfung im VHF-Bereich modulierbar ist;

iii) Detektieren eines die reflektierte Welle $v_r$ repräsentierenden ersten Signals und eines die ankommende Welle $v_i$ repräsentierenden zweiten Signals am Kopf der Leitung (L) durch ein zwischen dem Generator (G) und der Leitung (L) zwischengeschaltetes Modul, um die Entwicklung des Reflexionskoeffizienten $\Gamma$ im VHF-Bereich zu bestimmen und um aus diesem Reflexionskoeffizienten $\Gamma$ die Impedanz des zu prüfenden Zweipols (Y) zu bestimmen,
dadurch gekennzeichnet,

— daß die Leitung (L) durch eine Leitung mit konstanten Unterteilungen gebildet ist, die eine charakteristische Impedanz $R_c$ aufweist, die gleich der inneren Impedanz des Generators (G) ist,

— daß das zwischen dem Generator (G) und der Leitung (L) zwischengeschaltete Modul aus einem eine Eingangsklemme (C), die dazu bestimmt ist, mit dem Ausgang des Generators verbunden zu sein, und eine Ausgangsklemme (A), die dazu bestimmt ist, mit der Leitung (L) verbunden zu sein, umfassenden $\pi$-Widerstandsnetzwerk gebildet ist und daß das Modul gebildet ist aus:

· einem ersten Zweig umfassend erste und zweite Widerstände ($R_3$, $R_4$), die zwischen der Eingangsklemme (C) und Masse in Reihe geschaltet sind, und einen zwischen den beiden Widerständen ($R_3$, $R_4$) gelegenen ersten mittleren Ausgangs-Anschlußpunkt (B), wobei der zwischen Masse und dem ersten mittleren Ausgangs-Anschlußpunkt (B) gelegene erste Widerstand ($R_4$) des ersten Zweiges einen (Widerstands-)Wert von gleich 2/3 der charakteristischen Impedanz $R_c$ der Leitung (L) aufweist, währenddessen der zwischen der Eingangsklemme (C) und dem ersten mittleren Ausgangs-Anschlußpunkt (B) gelegene zweite Widerstand ($R_3$) dieses ersten Zweiges einen (Widerstands-)Wert von gleich 4/3 der charakteristischen Impedanz $R_c$ der Leitung (L) aufweist,

· einem zweiten Zweig umfassend erste und zweite Widerstände ($R_5$, $R_6$), die zwischen der Ausgangsklemme (A) und Masse in Reihe geschaltet sind, und einen zwischen den beiden Widerständen ($R_5$, $R_6$) gelegenen zweiten mittleren Ausgangs-Anschlußpunkt (D), wobei der zwischen Masse und dem zweiten mittleren Ausgangs-Anschlußpunkt (D) gelegene erste Widerstand ($R_6$) des zweiten Zweiges einen (Widerstands-)Wert von gleich 2/3 der charakteristischen Impedanz $R_c$ der Leitung (L) aufweist, währenddessen der zwischen der Ausgangsklemme (A) und dem zweiten mittleren Ausgangs-Anschlußpunkt (D) gelegene zweite Widerstand ($R_5$) dieses zweiten Zweiges einen (Widerstands-)Wert von gleich 4/3 der charakteristischen Impedanz $R_c$ der Leitung (L) aufweist, und

· einem dritten Zweig umfassend einen mit der Eingangsklemme (C) und der Ausgangsklemme (A) verbundenen Widerstand ($R_2$), der einen (Widerstands-)Wert von gleich 4/3 der charakteristischen Impedanz $R_c$ der Leitung (L) aufweist,
und dadurch, daß es die folgenden Schritte umfaßt:

— Messen eines ersten für die reflektierte Welle Vr repräsentativen Signals zwischen der Ausgangsklemme (A) und dem im ersten Zweig vorgesehenen ersten mittleren Ausgangs-Anschlußpunkt (B) und

— Messen eines zweiten für die ankommende Welle Vi repräsentativen Signals zwischen der Eingangsklemme (C) und dem im zweiten Zweig vorgesehenen zweiten mittleren Ausgangs-Anschlußpunkt (D).

2. Verfahren zur schnellen Prüfung nach Anspruch 1, dadurch gekennzeichnet, daß im Schritt ii) die Leitung (L) mit einer ankommenden periodischen Welle $v_i$ gespeist wird, deren Periodendauer während einer Prüfungsdauer von ungefähr 1 s in einem Größenordnungsbereich von 1 µs bis 5 ns wechselt.

3. Verfahren zur schnellen Prüfung nach einem der Ansprüche 1 oder 2, dadurch gekennzeichnet, daß im Verlauf des Schrittes ii) die Leitung (L) mit einer ankommenden periodischen Welle $v_i$ gespeist wird, deren Periode durch Wobbeln (vobulation) im VHF-Bereich gemäß einer linearen oder logarithmischen Zeitfunktion moduliert wird.

4. Verfahren zur schnellen Prüfung nach einem der Ansprüche 1 bis 3 zur Analyze von Kondensatoren, dadurch gekennzeichnet, daß der Absolutwert der Admittanz |Y| des Zweipols sich wie eine Folge von Treppenstufenwerten $G_j$ entwickelt, die im Schritt iii) auf der Grundlage der Gleichung

$$G_j = \frac{1}{R_c} \frac{1 - |\Gamma_j|}{1 + |\Gamma_j|}$$

bestimmt werden, in der
$R_c$ die charakteristische Impedanz der Leitung (L) und
$|\Gamma_j|$ den Absolutwert des Reflexionskoeffizienten repräsentiert.

5. Verfahren zur schnellen Prüfung nach Anspruch 4 zur Analyse von Kondensatoren in Gestalt eines Netzes aus n parallelen Zweigen, der jeder in Reihe einen Widerstand $R_j$ und eine Kapazität $C_j$ aufweist, dadurch gekennzeichnet, daß der Widerstand $R_j$ und die Kapazität $C_j$ im Schritt iii) auf der Grundlage der Gleichungen

$$1/R_j = G_j - G_{j-1}$$

20

EP 0 211 711 B1

in der $G_j$ und $G_{j-1}$ zwei aufeinanderfolgende Treppenstufen des Absolutwertes der Admittanz $|Y|$ repräsentieren und

$$C_j = (G_j - G_{j-1})/w_j$$

in der $\omega_j$ die kritische Kreisfrequenz des betrachteten Zweiges repräsentiert, bestimmt werden.

6. Verfahren zur schnellen Prüfung nach einem der Ansprüche 1 bis 5, dadurch gekennzeichnet, daß es die weiteren Schritte umfaßt, bestehend aus:

— Detektieren der Gesamtspannung $V_c$ zwischen Masse und der Ausgangsklemme (A) des π-Widerstandsmoduls und

— Bestimmen des Argumentes des Reflexionskoeffizienten Γ auf der Grundlage der Gleichung:

$$\arg \ \Gamma = 2\beta\ell + \arccos \frac{v_t^2 - v_i^2 - v_r^2}{2|v_r||v_i|}$$

in der

β die Phasenkonstante der Leitung (L) und
l die Länge der Leitung (L) repräsentiert.

7. Verfahren zur schnellen Prüfung nach einem der Ansprüche 1 bis 6, dadurch gekennzeichnet, daß der Schritt ii) unter Zuhilfenahme eines Oszillators (100) mit veränderbarer Frequenz bei automatischer Frequenzbandumschaltung realisiert ist.

8. Verfahren zur schnellen Prüfung nach Anspruch 7, dadurch gekennzeichnet, daß dem Sperrkreis des Oszillators (100) eine durch ein Sägezahnsignal (200) polarisierte Kapazitätsdiode (Varicap-Diode) ($D_v$) beigeordnet ist, die die Wobbelung innerhalb jedes Frequenzbandes sicherstellt, wobei der Sperrkreis des Oszillators eine Anzahl von Spulen (L301, L302, L303, L304) aufweist, die nach und nach zunehmend in Betrieb genommen werden, um die Frequenzbandumschaltung sicherzustellen.

9. Verfahren zur schnellen Prüfung nach Anspruch 8, dadurch gekennzeichnet, daß die Frequenzbandumschaltsignale (400), die die nach und nach zunehmende Inbetriebnahme der Spulen (L301, L302, L303, L304) des Sperrkreises des Oszillators sicherstellen, ausgehend von dem die Kapazitätsdiode ($D_v$) polarisierenden Sägezahnsignal (200) erzeugt werden.

10. Verfahren zur schnellen Prüfung nach Anspruch 9, dadurch gekennzeichnet, daß die Frequenzbandumschaltsignale am Ausgang eines durch den Sägezahnsignalgenerator (200) gesteuerten Schieberegisters (430) mit seriellem Eingang und parallelen Ausgängen erzeugt werden.

11. Schaltung zur schnellen Prüfung von passiven Zweipolen im VHF-Bereich zur Ausführung des Verfahrens nach einem der Ansprüche von 1 bis 10, umfassend:

— einen elektrischen Signalgenerator (G) mit einer im VHF-Bereich gelegenen veränderbaren Frequenz,

— eine an den Ausgang des zu prüfenden Zweipols (Y), der eine Abschlußimpedanz bildet, und an den Kopf des Generators (G) über ein zwischengeschaltetes Modul angeschlossene Leitung (L),

— das zur Trennung eines die reflektierte Welle $v_r$ repräsentierenden ersten Signals und eines die ankommende Welle $v_i$ repräsentierenden zweiten Signals geschaffen ist, wenn die Leitung (L) mit einer ankommenden periodischen Welle $v_i$ gespeist wird, deren Frequenz im VHF-Bereich während der Dauer der Prüfung moduliert ist, um die Entwicklung des Reflexionskoeffizienten Γ im VHF-Bereich zu bestimmen und um aus diesem Reflexionskoeffizienten Γ die Impedanz des zu prüfenden Zweipols zu bestimmen, dadurch gekennzeichnet, daß

— die Leitung (L) eine Leitung mit konstanten Unterteilungen ist, die eine charakteristische Impedanz $R_c$ aufweist, welche gleich der inneren Impedanz des Generators (G) ist,

— das zwischen dem Generator (G) und der Leitung (L) geschaltete Modul ein eine Eingangsklemme (C), die dazu bestimmt ist, mit Ausgang des Generators (G) verbunden zu sein, und eine Ausgangsklemme (A), die dazu bestimmt ist, mit der Leitung (L) verbunden zu sein, umfassendes π-Widerstandsnetzwerk ist, und daß das Modul gebildet ist aus:

· einem ersten Zweig umfassend erste und zweite Widerstände ($R_3$, $R_4$), die zwischen der Eingangsklemme (C) und Masse in Reihe geschaltet sind, und einen zwischen den beiden Widerständen ($R_3$, $R_4$) gelegenen ersten mittleren Ausgangs-Anschlußpunkt (B), wobei der zwischen Masse und dem ersten mittleren Ausgangs-Anschlußpunkt (B) gelegene erste Widerstand ($R_4$) des ersten Zweiges einen (Widerstands-)Wert von gleich 2/3 der charakteristischen Impedanz $R_c$ der Leitung (L) aufweist, währenddessen der zwischen der Eingangsklemme (C) und dem ersten mittleren Ausgangs-Anschlußpunkt (B) gelegene zweite Widerstand ($R_3$) dieses ersten Zweiges einen (Widerstands-)Wert von gleich 4/3 der charakteristischen Impedanz $R_c$ der Leitung (L) aufweist,

· einem zweiten Zweig umfassend erste und zweite Widerstände ($R_5$, $R_6$), die zwischen der Ausgangsklemme (A) und Masse in Reihe geschaltet sind, und einen zwischen den beiden Widerständen ($R_5$, $R_6$) gelegenen zweiten mittleren Ausgangs-Anschlußpunkt (D), wobei der zwischen Masse und dem

21

zweiten mittleren Ausgangs-Anschlußpunkt (D) gelegene erste Widerstand (R$_6$) des zweiten Zweiges einen (Widerstands-)Wert von gleich 2/3 der charakteristischen Impedanz R$_c$ der Leitung (L) aufweist, währenddessen der zwischen der Ausgangsklemme (A) und dem ersten mittleren Ausgangs-Anschlußpunkt (D) gelegene zweite Widerstand (R$_5$) dieses zweiten Zweiges einen (Widerstands-)Wert von gleich 4/3 der charakteristischen Impedanz R$_c$ der Leitung (L) aufweist, und

· einem dritten Zweig umfassend einen mit der Eingangsklemme (C) und der Ausgangsklemme (A) verbundenen Widerstand (R$_2$), der einen (Widerstands-)Wert von gleich 4/3 der charakteristischen Impedanz R$_c$ der Leitung (L) aufweist, und daß vergesehen sind:

— Einrichtungen, die zum Abgreifen eines ersten für die reflektierte Welle V$_r$ repräsentativen Signals zwischen der Ausgangsklemme (a) und dem im ersten Zweig vorgesehenen ersten mittleren Ausgangs-Anschlußpunkt (B) geeignet sind,

— Einrichtungen, die zum Abgreifen eines zweiten für die ankommende Welle V$_i$ repräsentativen Signals zwischen der Eingangsklemme (C) und dem im zweiten Zweig vorgesehenen zweiten mittleren Ausgangs-Anschlußpunkt (D) geeignet sind, und

— Einrichtungen, die geeignet sind, die Beziehung zwischen dem ersten Signal und dem zweiten Signal zu bilden, um ein für den Absolutwert des Reflexionskoeffizienten |Γ| repräsentatives Signal zu bilden.

12. Schaltung zur schnellen Prüfung nach Anspruch 11, dadurch gekennzeichnet, daß der Generator (G) entsprechend eingerichtet ist, um eine ankommende periodische Welle v$_i$, deren Periodendauer während einer Prüfungsdauer von ungefähr 1 s in einem Größenordnungsbereich von 1 µs bis 5 ns wechselt, in die Leitung (L) einzuspeisen.

13. Schaltung zur schnellen Prüfung nach einem der Ansprüche 11 und 12 zur Analyse von Kondensatoren, dadurch gekennzeichnet, daß sie geeignete Einrichtungen zur Bestimmung der Stufen (G$_j$) des Absolutwertes der Admittanz |Y| des Zweipols auf der Basis der Gleichung

$$G_j = \frac{1}{R_c} \frac{1 - |\Gamma_j|}{1 + |\Gamma_j|}$$

umfaßt, in der

R$_c$ die charakteristische Impedanz der Leitung (L) und
|Γ$_j$| den Absolutwert des Reflexionskoeffizienten repräsentiert.

14. Schaltung zur schnellen Prüfung nach Anspruch 13 zur Analyse von Kondensatoren in Gestalt eines Netzes aus n parallelen Zweigen, der jeder in Reihe einen Widerstand R$_j$ und eine Kapazität C$_j$ aufweist, dadurch gekennzeichnet, daß sie umfaßt:

— Einrichtungen, die geeignet sind, den Widerstand R$_j$ auf der Grundlage der Gleichung

$$1/R_j = G_j - G_{j-1}$$

zu bestimmen, in der G$_j$ und G$_{j-1}$ zwei aufeinanderfolgende Treppenstufen des Absolutwertes der Admittanz |Y| repräsentieren und

— Einrichtungen, die geeignet sind, die Kapazität C$_j$ auf der Grundlage der Gleichung

$$C_j = (G_j - G_{j-1})/w_j$$

zu bestimmen, in der ω$_j$ die kritische Kreisfrequenz des betrachteten Zweiges repräsentiert.

15. Schaltung zur schnellen Prüfung nach einem der Ansprüche 11 bis 14, dadurch gekennzeichnet, daß sie ferner umfaßt:

— Einrichtungen, die geeignet sind, die Gesamtspannung V$_c$ zwischen Masse und der Ausgangsklemme (A) des π-Widerstandsmoduls zu detektieren und

— Einrichtungen, die geeignet sind, das Argument des Reflexionskoeffizienten Γ auf der Grundlage der Gleichung:

$$\arg \Gamma = 2\beta\ell + \arccos \frac{V_t^2 - V_i^2 - V_r^2}{2|V_r||V_i|}$$

zu bestimmen, in der

β die Phasenkonstante der Leitung (L) und
l die Länge der Leitung (L) repräsentiert.

16. Schaltung zur Prüfung nach einem der Ansprüche 11 bis 15, dadurch gekennzeichnet, daß der

22

## EP 0 211 711 B1

Generator (G) einen Oszillator (100) variabler Frequenz bei automatischer Frequenzbandumschaltung umfaßt.

17. Schaltung zur Prüfung nach Anspruch 16, dadurch gekennzeichnet, daß sie einen Sägezahnsignalgenerator (200) aufweist, daß dem Sperrkreis des Oszillators (100) eine durch das Sägezahnsignal (200) polarisierte Kapazitätsdiode (Varicap-Diode) ($D_v$) beigeordnet ist, die die Wobbelung innerhalb jedes Frequenzbandes sicherstellt, wobei der Sperrkreis des Oszillators eine Anzahl von Spulen (L301, L302, L303, L304) aufweist, die abwechselnd in Betrieb genommen werden, um die Frequenzbandumschaltung sicherzustellen.

18. Schaltung zur Prüfung nach Anspruch 17, dadurch gekennzeichnet, daß der Sägezahnsignalgenerator (200) in gleicher Weise die Frequenzbandumschaltsignale (400) erzeugt, die alternativ die Inbetriebnahme der Spulen (L301, L302, L303, L304) des Sperrkreises des Oszillators sicherstellen.

19. Schaltung zur Prüfung nach Anspruch 18, dadurch gekennzeichnet, daß sie ein Schieberegister (430) mit seriellem Eingang und parallelen Ausgängen aufweist, das durch den Sägezahngenerator (200) gesteuert ist und am Ausgang die Frequenzbandumschaltsignale erzeugt.

### Claims

1. A method for rapidly testing passive two-terminal devices in the VHF range, said method comprising the steps of:

i) connecting an electrical signal generator (G) having its frequency in the VHF range, to the head of a line (L), and connecting the two-terminal device (Y) to be tested to the other end of the line (L) as a terminating impedance,

ii) feeding the line (L), using the generator (G), with a periodic incident wave $V_i$ having its frequency capable of modulation in the VHF range during the test time,

iii) detecting at the head of the line (L), a first signal which is representative of the reflected wave $v_r$ and a second signal which is representative of the incident wave $v_i$ by way of a module which is inserted between the generator (G) and the line (L), so as to define the behaviour of the reflection coefficient on the VHF range and to determine the impedance of the two-terminal device to be tested from this reflection coefficient,

characterized by the fact that:

— the line (L) is a distributed constant transmission line having a characteristic impedance $R_c$ which is equal to the internal impedance of the generator (G);

— the module inserted between the generator (G) and the line (L) comprises a π resistive vetwork comprising a input terminal (C) to be connected to the output of the generator (G) and an output terminal (A) to be connected to the line (L),

said module comprising:

. a first leg comprising a first and a second resistors ($R_3$, $R_4$) connected in series between the input terminal (C) and the ground, and a first output intermediate terminal (B), between these two resistors ($R_3$, $R_4$), wherein the first resistor ($R_4$) of said first leg, which is connected between the ground and the first output intermediate terminal (B) has a value equal to 2/3 of the characteristic impedance $R_c$ of the line (L), while the second resistor $R_3$ of said first leg, which is connected between the input terminal (C) and the first output intermediate terminal (B) has a value equal to 4/3 of the characteristic impedance of the line (L),

. a second leg comprising a first and a second resistors ($R_5$, $R_6$) connected in series between the output terminal (A) and the ground, and a second output intermediate terminal (D) between the two last resistors ($R_5$, $R_6$), wherein the first resistor ($R_6$) of said second leg, which is connected between the ground and the second output intermediate terminal (D) has a value equal to 2/3 of the characteristic impedance ($R_c$) of the line (L), while the second resistor $R_5$ of said second leg, which is connected between the output terminal (D) and the second output intermediate terminal (A) has a value equal to 4/3 of the characteristic impedance $R_c$ of the line (L), and

. a third leg comprising a resistor ($R_2$) connected between the input terminal (C) and the output terminal (A), and which has a value equal to 4/3 of the characteristic impedance $R_c$ of the line (L), and said method further comprising the steps of:

— measuring a first signal representative of the reflected wave $V_r$, between the output terminal (A) and the first output intermediate terminal (B) on the first leg, and

— measuring a second signal representative of the incident wave $V_i$, between the input terminal (C) and the second output intermediate terminal (D) on the second leg.

2. A method according to claim 1, wherein during step ii) the line (L) is fed with a periodic incident wave $v_i$ whose period varies over a range from about 1 μs to about 5 ns over a test duration of about 1 s.

3. A method according to one of claims 1 or 2, wherein during step ii) the line (L) is fed with a periodic incident wave $v_i$ whose period is modulated by wobbulation over the VHF range using a linear or a logarithmic function of time.

4. A method according to one of claims 1 to 3 for analyzing capacitors, wherein the modulus of the admittance $|Y|$ of the two-terminal network constituted by the capacitor varies as a series of levels of value $G_j$, which levels are determined during step iii) on the basis of the following equation:

23

$$G_j = \frac{1}{R_c} \frac{1 - |\Gamma_j|}{1 + |\Gamma_j|}$$

where
R$_c$ is the characteristic impedance of the line (L), and
$|\Gamma_j|$ is the modulus of the reflection coefficient.

5. A method according to claim 4, for analyzing capacitors in the form of a ladder network comprising $n$ parallel branches each of which is constituted by a resistance R$_j$ and a capacitance C$_j$ connected in series, wherein the resistance R$_j$ and the capacitance C$_j$ are determined during step iii) on the basis of the equation:

$$1/R_j = G_j - G_{j-1}$$

where G$_j$ and G$_{j-1}$ are two successive levels in the modulus of the admittance $|Y|$, and the equation

$$C_j = (G_j - G_{j-1})/w_j$$

where w$_j$ is the resonant angular frequency of the j-th branch.

6. A method according to one of claims 1 to 5 wherein the method further comprises the steps of:
— detecting the total voltage V$_c$ between the ground and the output terminal (A) of the π resistive module, and
— determining the argument of the reflection coefficient on the basis of the equation:

$$\arg \Gamma = 2\beta\ell + \arcos \frac{V_t{}^2 - V_i{}^2 - V_r{}^2}{2|V_r||V_i|}$$

in which
β represents the phase constant of the line (L) and
I represents the length of the line (L).

7. A method according to one of claims 1 to 6, wherein step ii) is performed by means of a variable frequency oscillator with automatic frequency band switching.

8. A method according to claim 7, wherein the wavetrap of the oscillator (100) is associated with a varicap diode (D$_v$) which is biased by a sawtooth signal (200) for providing wobbulation within each frequency band, the wave trap of the oscillator including a plurality of inductors (L301, L302, L303, L304) which are successively switched into or out of circuit in order to provide said frequency band switching.

9. A method according to claim 8, wherein the frequency band switching signals (400) for successively switching the inductors (L301, L302, L303, L304) of the wavetrap into or out of circuit are generated from the sawtooth signal (200) which biases the varicap diode (D$_v$).

10. A method according to claim 9 wherein the frequency band switching signals are generated at the outputs from a serial-in, parallel-out shift register (430) controlled by the signal from the sawtooth generator (200).

11. Apparatus for rapidly testing passive two-terminal devices in the VHF range for implementing the method according to one of claims 1 to 10, said apparatus comprising:
an electric signal generator (G) capable of generating a variable frequency in the VHF range;
a line (L) connected at its output to the two terminal device to be tested (Y) as a terminating terminal, and connected at its head to the generator (G) by way of a module capable of separating a first signal which is representative of the reflected wave v$_r$ and a second signal which is representative of the incident wave v$_i$ when the line (L) is fed with a periodic incident wave v$_i$ having a frequence modulated in the VHF range during the test time, to define the behaviour of the reflection coefficient on the VHF range and to determine the impedance of the two terminal device to be tested from the reflection coefficient,
characterized by the fact that:
— the line (L) is a distributed constant transmission line having a characteristic impedance (R$_c$) which is equal to the internal impedance of the generator (G),
— the module inserted between the generator (G) and the line (L) comprises a π resistive vetwork comprising a input terminal (C) to be connected to the output of the generator (G) and an output terminal (A) to be connected to the line (L),
said module comprising:
. a first leg comprising a first and a second resistors (R$_3$, R$_4$) connected in series between the input

24

terminal (C) and the ground, and a first output intermediate terminal (B), between these two resistors ($R_3$, $R_4$) wherein the first resistor ($R_4$) of said first leg, which is connected between the ground and the first output intermediate terminal (B) has a value equal to 2/3 of the characteristic impedance $R_c$ of the line (L), while the second resistor ($R_3$) of said first leg, which is connected between the input terminal (C) and the first output intermediate terminal (B) has a value equal to 4/3 of the characteristic impedance of the line (L),

. a second leg comprising a first and a second resistors ($R_5$, $R_6$) connected in series between the output terminal (A) and the ground, and a second output (D) intermediate terminal between the two last resistors ($R_5$, $R_6$), wherein the first resistor ($R_6$) of said second leg, which is connected between the ground and the second output intermediate terminal (D) has a value equal to 2/3 of the characteristic impedance $R_c$ of the line (L), while the second resistor ($R_5$) of said second leg, which is connected between the output terminal (D) and the second output intermediate terminal (A) has a value equal to 4/3 of the characteristic impedance $R_c$ of the line (L), and

. a third leg comprising a resistor ($R_2$) connected between the input terminal (C) and the output terminal (A), and which has a value equal to 4/3 of the characteristic impedance $R_c$ of the line (L), and comprising:

— means for measuring a first signal representative of the reflected wave $V_r$, between the output terminal (A) and the first output intermediate terminal (B) on the first leg, and

— means for measuring a second signal representative of the incident wave $V_i$, between the input terminal (C) and the second output intermediate terminal (D) on the second leg, and

— means for forming the ratio between the first signal and the second signal to generate a signal representative of the modulus of the reflection coefficient.

12. Apparatus according to claim 11, wherein the generator (4) is adapted to feed the line (L) with a periodic incident wave $v_i$ whose period varies over a range from about 1 µs to about 5 ns with a test duration of about 1 s.

13. Apparatus according to one of claims 11 to 12, for analyzing capacitors, wherein it comprises means suitable for determining the levels $G_j$ in the modulus of the admittance $|Y|$ of the two-terminal network constituted by the capacitor using the equation:

$$G_j = \frac{1}{R_c} \frac{1 - |\Gamma_j|}{1 + |\Gamma_j|}$$

where

$R_c$ is the characteristic impedance of the line, and

$|\Gamma_j|$ is the modulus of the reflection coefficient.

14. Apparatus according to claim 13, for analyzing capacitors in the form of a ladder network comprising $n$ parallel branches each of which is constituted by a resistance $R_j$ and a capacitance $C_j$ connected in series, wherein the apparatus comprises:

means suitable for determining the resistance $R_j$ the basis of the equation:

$$1/R_j = G_j - G_{j-1}$$

where $G_j$ and $G_{j-1}$ are two successive levels in the modulus of the admittance $|Y|$; and

means suitable for determining the capacitance $C_j$ on the basis of the equation

$$C_j = (G_j - G_{j-1})/w_j$$

where $w_j$ is the resonant angular frequency of the j-th branch.

15. Apparatus according to one of claims 11 to 14 comprising

— means for detecting the total voltage $V_c$ between the ground and the output terminal (A) of the $\pi$ resistive module, and

— determining the argument of the reflection coefficient on the basis of the equation:

$$\arg \Gamma = 2\beta\ell + \arccos \frac{V_t^2 - V_i^2 - V_r^2}{2|V_r||V_i|}$$

in which

$\beta$ represents the phase constant of the line (L) and

l represents the length of the line (L).

16. Apparatus according to one of claims 11 to 15, wherein the generator (G) includes a variable frequency oscillator 100 with automatic frequency band switching.

17. Apparatus according to claim 16, including a sawtooth signal generator (200) and wherein the wavetrap of the oscillator is associated with a varicap diode ($D_v$) which is biased by the sawtooth signal (200) from said generator for providing wobbulation within each frequency band, the wavetrap of the oscillator including a plurality of inductors (L301, L302, L303, L304) which are successively switched into or out of circuit in order to provide said frequency band switching.

18. Apparatus according to claim 17, wherein the sawtooth signal generator (200) also generates the frequency band switching signals (400) for progressively switching the inductors (L301, L302, L303, L304) of the oscillator wavetrap into or out of service.

19. Apparatus according to claim 18, including a serial-in, parallel-out shift register (430) controlled by the sawtooth signal generator (200), with the signals present on the outputs of the shift register constituting the frequency band switching signals.

FIG_1

FIG_2

FIG_3

FIG_4

FIG_5

FIG_6

# FIG.7

FIG. 8

FIG. 9

4

EP 0 211 711 B1

FIG.10

FIG.11

5

FIG_12

a) Réponse d'un condensateur équivalent à une branche $R_1C_1$ ( $R_1 = 180\Omega$, $C_1 = 100pf$ )
b)       "        "        "        "    $R_2C_2$ ( $R_2 = 180\Omega$, $C_2 = 1nf$ )

FIG_13

EP 0 211 711 B1

Réponse d'un condensateur équivalent à deux branches $R_1 C_1$, $R_2 C_2$ ( $R_1 = R_2 = 180\,\Omega$, $C_1 = 100\,pf$, $C_2 = 1\,nf$ )

Courbe théorique

Courbe expérimentale

FIG. 14

EP 0 211 711 B1

Réponse expérimentale d'un condensateur
équivalent à deux branches $R_3 C_3$ ; $R_4 C_4$
( $R_3 = R_4 = 180 \, \Omega$, $C_3 = 1nF$ ; $47 pf$ )

FIG.15

FIG. 16A

FIG. 16B

FIG. 16C